# EUROPEAN PATENT SPECIFICATION

(11) **EP 4 207 724 B1**
(45) Date of publication and mention of the grant of the patent: **11.03.2026**
(21) Application number: 21872776.6
(22) Date of filing: 07.09.2021
(51) Int. Cl.: H04M 1/23, H01Q 1/24, H05K 7/20, H01H 13/48, H04M 1/02, G06F 1/20, H01Q 21/08, H01Q 21/28, H01Q 9/04, H01Q 1/42, H01H 13/14, H01Q 1/44

(54) **KEY ASSEMBLY AND ELECTRONIC DEVICE COMPRISING SAME**
TASTENANORDNUNG UND ELEKTRONISCHE VORRICHTUNG DAMIT
ENSEMBLE DE CLÉ ET DISPOSITIF ÉLECTRONIQUE LE COMPRENANT

(30) Priority: 22.09.2020 KR 20200122131
(43) Date of publication of application: 05.07.2023
(73) Proprietor: Samsung Electronics Co., Ltd., Suwon-si, Gyeonggi-do 16677 (KR)
(72) Inventor: LIM, Jinho, Suwon-si Gyeonggi-do 16677 (KR); JUNG, Minsu, Suwon-si Gyeonggi-do 16677 (KR); HEO, Joon, Suwon-si Gyeonggi-do 16677 (KR)
(74) Representative: HGF
(86) International application number: PCT/KR2021/012087
(87) International publication number: WO 2022/065746

(56) References cited:
- EP-A1- 3 657 598
- WO-A1-2020/153694
- KR-A- 20130 108 752
- KR-A- 20170 013 682
- KR-A- 20170 035 707
- KR-B1- 102 113 584
- US-A1- 2009 256 759

## Description

### [Technical Field]

Various embodiments of the disclosure relate to a key assembly and an electronic device including the same.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling or e-wallet function. Such electronic devices become compact enough for users to carry in a convenient way.

In communication devices included in electronic devices, in order to meet demand for soaring wireless data traffic since the 4G (third generation) communication system came onto the market, there are ongoing efforts to develop next-generation communication systems, e.g., 5G communication systems or pre-5G communication systems. For higher data rates, next-generation communication systems adopt high frequency bands of a few tens of GHz, e.g., 6GHz or more and 300GHz or less, such as those of mmWave. To mitigate pathloss on the high frequency band and increase the reach of radio waves, the following techniques are taken into account for the next-generation communication system: beamforming, massive multi-input multi-output (MIMO), full dimensional MIMO (FD-MIMO), array antenna, analog beamforming, and large scale antenna.

WO 2020/153694 A1 discloses an electronic device comprising: a conductive housing comprising a first surface facing in a first direction, a second surface facing in a second direction opposite to the first direction, and a side surface surrounding at least a part of a space formed between the first surface and the second surface; a printed circuit board seated inside the housing; and a side key fastened in an edge area of the housing. The side key comprises a side key circuit board comprising: a button unit having a surface covering a first through-hole formed through the side surface of the housing and having another surface exposed outwards; an operation unit extending from the surface of the button unit covering the first through-hole towards the inside of the housing such that at least a part of the extension is inserted into the first through-hole, and the inserted part moves in a third direction parallel with a direction perpendicular to the side surface of the housing according to whether or not the button unit is pressurized; an outer contact-point unit pressurized by a movement of the operation unit; an inner contact-point unit configured to contact the outer contact-point unit according to whether or not the outer contact-point unit is pressurized; and a switch module for producing an electric signal by means of contact between the outer contact-point unit and the inner contact-point unit. In addition, the side key comprises: a side key bracket for fixing and supporting the side key circuit board, at least a part of the side key circuit board being seated on the side key bracket; and an antenna using the first through-hole as an antenna opening for transmitting/receiving radio waves. Various other embodiments conceivable through the present document are possible.

EP 3 657 598 A1 discloses an electronic device. The electronic device includes a housing, a display exposed through at least a portion of the housing, a battery disposed in the housing, an antenna module disposed in the housing and spaced apart from the battery, a first electronic component positioned between the antenna module and the battery, a first heat dissipation member disposed to partially overlap the first electronic component and to extend toward the antenna module, a frame disposed to partially overlap the first heat dissipation member, surround at least a part of the first electronic component, and form a part of an outer appearance of the electronic device, and a heat insulation member interposed between the frame and the first heat dissipation member.

### [Detailed Description of the Invention]

### [Technical Problem]

The invention is defined by appended independent claim 1. Further embodiments of the invention are defined by the dependent claims.

In general, an antenna structure disposed within an electronic device may be disposed near the edge of the electronic device (e.g., near the edge of the housing) to maintain radiation performance. For example, a housing of an electronic device may include a metal part, and radiation performance may decrease when an antenna structure is disposed adjacent to the metal part. As another example, the antenna structure may be disposed near a non-metallic curved portion of the rear cover of the housing, but due to the curved structure of the rear cover, the antenna structure may be moved and mounted in the electronic device. Accordingly, the mounting space in the electronic device may be overall reduced and, as the curved structure does not entirely cover the antenna structure, radiation performance may decrease.

According to various embodiments of the disclosure, as an antenna structure is disposed inside a key assembly, the mounting space of the electronic device may be enhanced.

According to various embodiments of the disclosure, it is possible to enhance the radiation performance by disposing an antenna structure inside a key assembly and adjacent to the outside and forming a portion of the key assembly positioned in the radiation area of the antenna structure of a non-metallic material.

### [Technical Solution]

According to various embodiments of the disclosure, an electronic device may comprise a housing including a first opening, a key case including an outer surface formed to face in a first direction to cover the first opening and a recess formed to face in a second direction opposite to the first direction, an antenna structure seated in the recess of the key case and including an array of a plurality of conductive plates facing in the first direction, a key circuit structure for a key operation, disposed in the second direction of the antenna structure, a first bracket formed to surround at least a portion of the antenna structure and disposed between the antenna structure and the key circuit structure, and a second bracket supporting the key circuit structure and including a first portion formed to face the antenna structure and a second portion disposed in a direction different from the first portion and formed to face an inner area of the housing.

According to various embodiments of the disclosure, a key assembly may comprise a key case including an outer surface formed to be exposed on a side of an electronic device and a recess formed to face in a second direction opposite to a first direction in which the outer surface faces, an antenna structure seated in the recess of the key case and including an array of a plurality of conductive plates facing in the first direction, a key circuit structure for a key operation, disposed in the second direction of the antenna structure, a first bracket formed to surround at least a portion of the antenna structure and disposed between the antenna structure and the key circuit structure, and a second bracket supporting the key circuit structure, formed to be connected while surrounding at least a portion of the key circuit structure to provide a path for passage of heat generated from the antenna structure, and disposed to face the first bracket.

### [Advantageous Effects]

According to various embodiments, in the electronic device, the antenna structure is inserted in the key assembly, providing both antenna radiation and key operation.

According to various embodiments of the disclosure, in the electronic device, the antenna structure is mounted in the outermost area of the electronic device, enhancing radiation performance.

According to various embodiments of the disclosure, in the electronic device, it is possible to enhance the degree of freedom of arrangement of electronic device components by efficiently utilizing the arrangement space of the antenna structure.

According to various embodiments of the disclosure, the electronic device may support a high-frequency band (e.g., mmWave) antenna.

Effects of the disclosure are not limited to the foregoing, and other unmentioned effects would be apparent to one of ordinary skill in the art from the following description.

### [Brief Description of Drawings]

FIG. 1 is a block diagram illustrating an electronic device in a network environment according to various embodiments;
FIG. 2 is a view illustrating an unfolded state of an electronic device according to various embodiments of the disclosure.
FIG. 3 is a perspective view illustrating an electronic device according to various embodiments of the disclosure;
FIG. 4 is a block diagram illustrating an electronic device in a network environment including a plurality of cellular networks according to various embodiments;
FIGS. 5A to 5C are views illustrating an embodiment of a structure of a third antenna module described in connection with FIG. 4, according to various embodiments of the disclosure;
FIG. 6 is a perspective view illustrating a key assembly of an electronic device according to various embodiments of the disclosure;
FIG. 7 is a see-through view of a key assembly of an electronic device, as viewed from a side thereof, according to various embodiments of the disclosure;
FIG. 8 is an exploded perspective view illustrating a key assembly according to various embodiments of the disclosure;
FIG. 9 is a top view illustrating a configuration in which components of a key assembly are separated to install the key assembly in an electronic device according to various embodiments of the disclosure;
FIG. 10 is a perspective view illustrating a state in which a key case of a key assembly, an antenna structure, and a first bracket are assembled according to various embodiments of the disclosure;
FIGS. 11A and 11B are cross-sectional views taken along C-C' of the key assembly of FIG. 8, according to various embodiments of the disclosure;
FIG. 12 is a top view illustrating a state in which a key case of a key assembly, an antenna structure, a first bracket, and a key circuit unit are assembled according to various embodiments of the disclosure;
FIG. 13 is a top view illustrating a state in which a key case of a key assembly, an antenna structure, a first bracket, and a key circuit structure are assembled according to various embodiments of the disclosure;
FIG. 14 is a see-through view of an assembled state of a key case of a key assembly, an antenna structure, a first bracket, a key circuit structure, and a second bracket, as viewed from the top, according to various embodiments of the disclosure;
FIG. 15 is a perspective view illustrating a structure of a second bracket of a key assembly according to various embodiments of the disclosure;
FIG. 16 is a view illustrating a thermal conduction path of a key assembly according to various embodiments of the disclosure;
FIG. 17 is a flowchart illustrating an order of assembling a key assembly according to various embodiments of the disclosure; and
FIGS. 18A to 18E are schematically illustrating an order of assembling a key assembly according to various embodiments of the disclosure.

### [Mode for Carrying out the Invention]

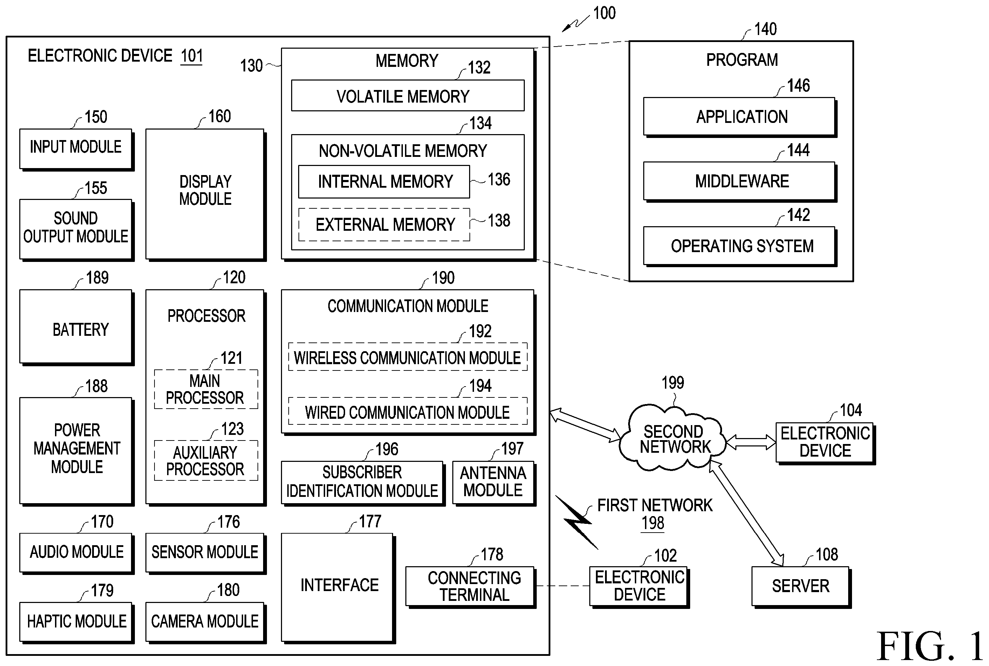

FIG. 1 is a block diagram illustrating an electronic device 101 in a network environment 100 according to various embodiments of the disclosure.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

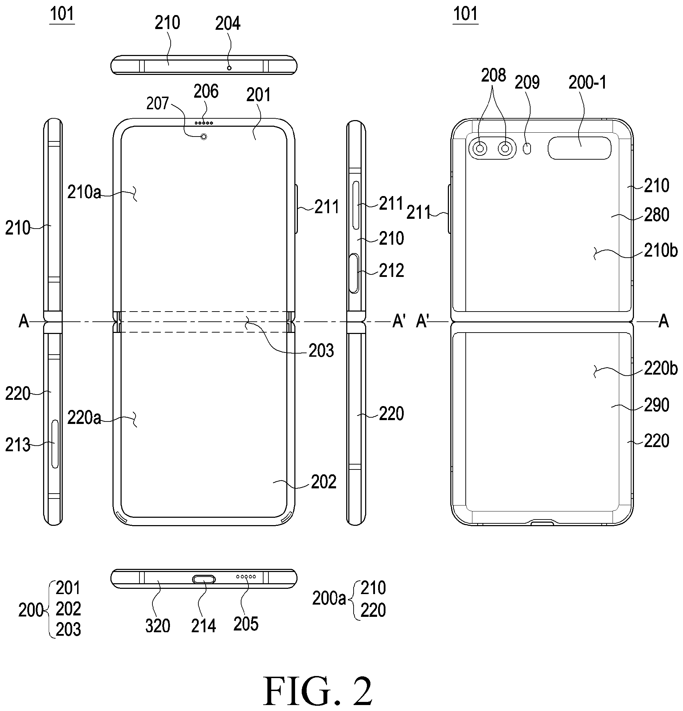

FIG. 2 is a view illustrating an unfolded state of an electronic device 101 according to various embodiments of the disclosure. FIG. 2 illustrates various views of the front, back, and side of the electronic device 101 together.

Referring to FIG. 2, according to various embodiments, an electronic device 101 may include a foldable housing 200a and a flexible or foldable display 200 (hereinafter, simply "flexible display 200") (e.g., the display device 160 of FIG. 1) disposed in a space formed by the foldable housing 200a.

According to various embodiments, the surface on which the display 200 is disposed may be defined as a front surface of the electronic device 101. At least a portion of the front surface of the electronic device 101 may be formed of a substantially transparent front plate (e.g., a glass plate or polymer plate including various coat layers). The opposite surface of the front surface may be defined as a rear surface of the electronic device 101. The rear surface of the electronic device 101 may be formed by a substantially opaque rear plate (hereinafter, referred to as a 'rear cover'). The rear cover may be formed of, e.g., laminated or colored glass, ceramic, polymer, metal (e.g., aluminum, stainless steel (STS), or magnesium), or a combination of at least two thereof. The surface surrounding the space between the front and back surfaces may be defined as a side surface of the electronic device 101. The side surface may be formed by a side bezel structure (or a "side member") that couples to the front plate and the rear plate and includes a metal and/or polymer. According to an embodiment, the rear cover and the side bezel plate may be integrally formed together and include the same material (e.g., a metal, such as aluminum).

According to various embodiments, the electronic device 101 may include at least one or more of a display 200, audio modules 204, 205, and 206, a sensor module 209, camera modules 207 and 208, key input devices 211, 212, and 213, and a connector hole 214.

According to various embodiments, the display 200 may be a display at least a portion of which may be transformed into a flat or curved surface. According to an embodiment, the display 200 may include a folding area 203, a first area 201 disposed on one side of the folding area 203 (e.g., the upper side of the folding area 203 of FIG. 2), and a second area 202 disposed on the opposite side of the folding area 203 (e.g., the lower side of the folding area 203 of FIG. 2). However, the segmentation of the display 200 as shown in FIG. 2 is merely an example, and the display 200 may be divided into a plurality of (e.g., four or more, or two) areas depending on the structure or function of the display 200. For example, in the embodiment illustrated in FIG. 2, the display 200 may be divided into the areas by the folding area 203 or folding axis A-A' but, in another embodiment, the display 200 may be divided into the areas with respect to another folding area or another folding axis (e.g., a folding axis perpendicular to the folding axis A-A').

According to various embodiments, the electronic device 101 may transform into a folded state or an unfolded state. The electronic device 101 may be folded in two types, e.g., 'in-folding' in which it is folded so that the front surface of the electronic device 101 forms an acute angle and 'out-folding' in which it is folded so that the front surface of the electronic device 101 forms an obtuse angle, as viewed in the direction of the folding axis (e.g., A-A' of FIG. 2). For example, in the in-folded state of the electronic device 101, the first surface 210a may face the third surface 220a and, in the fully unfolded state, the third direction may be identical to the first direction. As another example, in the out-folded state of the electronic device 101, the second surface 210b may face the fourth surface 220b.

The in-folding type may mean a state in which the display 200 is not exposed to the outside in the fully folded state. The out-folding type may mean a state in which the display 200 is exposed to the outside in the fully folded state. Although an in-folding type electronic device 101 is primarily described below for convenience purposes, it should be noted that the descriptions may also apply to an out-folding type electronic device 101.

According to various embodiments, the audio modules 204, 205, and 206 may include a microphone hole 204 and speaker holes 205 and 206. A microphone for acquiring external sounds may be disposed in the microphone hole 204. In some embodiments, a plurality of microphones may be disposed to detect the direction of the sound. The speaker holes 205 and 206 may include an external speaker hole 205 and a phone receiver hole 206. According to an embodiment, the speaker holes 205 and 206 and the microphone hole 204 may be implemented as a single hole, or speakers may be rested without the speaker holes 205 and 206 (e.g., piezo speakers). Various changes may be made to the position and number of microphone holes 204 and speaker holes 205 and 206 according to an embodiment.

According to various embodiments, the camera modules 207 and 208 may include a first camera device 207 disposed on the first surface 210a of the first housing 310 of the electronic device 101 and a second camera device 208 disposed on the second surface 210b. The electronic device 101 may further include a flash (not shown). The camera devices 207 and 208 may include one or more lenses, an image sensor, and/or an image signal processor. The flash (not shown) may include, e.g., a light emitting diode (LED) or a xenon lamp.

According to various embodiments, the sensor modules 209 may generate an electrical signal or data value corresponding to an internal operating state or external environmental state of the electronic device 101. Although not shown in the drawings, the electronic device 101 may additionally or alternatively include a sensor module other than the sensor module 209 provided on the second surface 210b of the first housing 310. The electronic device 101 may include, as the sensor module, at least one of a proximity sensor, a fingerprint sensor, an HRM sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to various embodiments, the key input devices 211, 212, and 213 may be disposed on a side surface of the foldable housing 200a. According to another embodiment, the electronic device 101 may exclude all or some of the above-mentioned key input devices 211, 212, and 213 and the excluded key input devices may be implemented in other forms, e.g., as soft keys, on the display 200. In some embodiments, the key input device may be configured to implement key input by a sensor module.

According to various embodiments, the connector hole 214 may be configured to receive a connector (e.g., a USB connector) for transmitting/receiving power and/or data to/from an external electronic device or, additionally or alternatively, a connector for transmitting/receiving audio signals to/from an external electronic device.

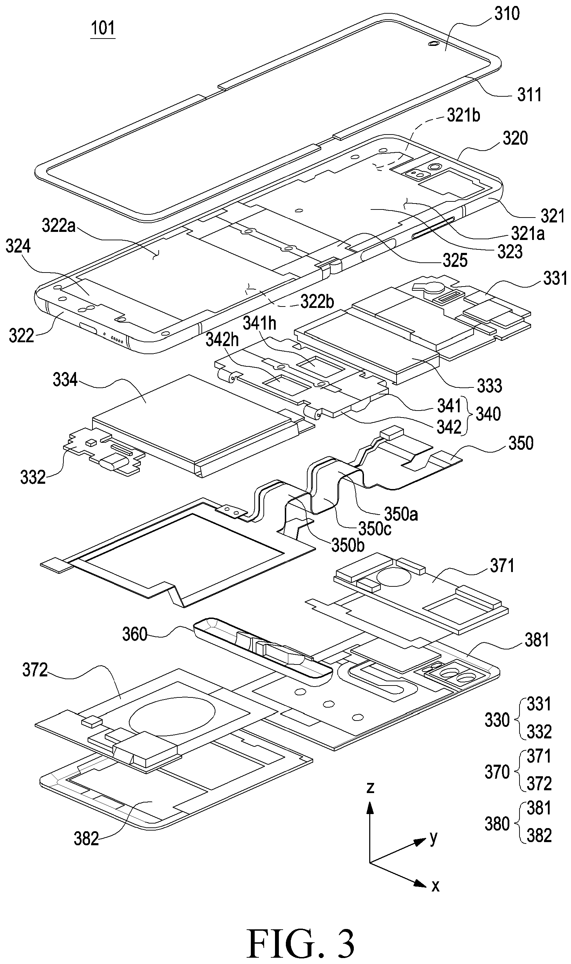

According to various embodiments, the foldable housing 200a may include a first housing structure 210, a second housing structure 220, a first rear cover 280, a second rear cover 290, and a hinge structure. (e.g., the hinge structure 340 of FIG. 3). The foldable housing 200a of the electronic device 101 are not limited to the shape and coupling shown in FIG. 2 but may rather be implemented in other shapes or via a combination and/or coupling of other components. For example, the first housing structure 210 and the first rear cover 280 may be integrally formed with each other, and the second housing structure 220 and the second rear cover 290 may be integrally formed with each other. According to various embodiments of the disclosure, 'housing structure' may be a component obtained by combining and/or coupling various components, including the housing.

According to various embodiments, the first housing structure 210 may be connected to the hinge structure (e.g., the hinge structure 340 of FIG. 3 described below) and may include a first surface 210a facing in a first direction and a second surface 210b facing in a second direction opposite to the first direction. The second housing 220 may be connected to the hinge structure (e.g., the hinge structure 340 of FIG. 3) and may include a third surface 220a facing in a third direction and a fourth surface 220b facing in a fourth direction opposite to the third direction and may be rotated from the first housing 210 about the hinge structure (or folding axis A-A').

According to various embodiments, the first housing structure 210 and the second housing structure 220 may be disposed on both sides (or upper/lower sides) of the folding axis A-A', and may have an overall symmetrical shape with respect to the folding axis A-A'. The angle or distance between the first housing structure 210 and the second housing structure 220 may be varied depending on whether the electronic device 101 is in the unfolded state, the folded state, or the partially unfolded (or partially folded) intermediate state. According to an embodiment, the first housing structure 210 may further include various sensors unlike the second housing structure 220 but, in the remaining area, the first housing 210 and the second housing 220 may have symmetrical shapes with each other.

According to various embodiments, at least a portion of the first housing structure 210 and the second housing structure 220 may be formed of a metal or a non-metallic material having a predetermined degree of rigidity to support the display 200. At least a portion formed of metal may provide a ground plane of the electronic device 101 and may be electrically connected with a ground line formed on a printed circuit board (e.g., the printed circuit board 330 of FIG. 3).

According to various embodiments, the first rear cover 280 may be disposed on one side of the folding axis A-A' on the rear surface of the electronic device 101 and have, e.g., a substantially rectangular periphery which may be surrounded by the first housing structure 210. Similarly, the second rear cover 290 may be disposed on the opposite side of the folding axis A-A' on the rear surface of the electronic device 101 and its periphery may be surrounded by the second housing structure 220.

According to various embodiments, the first rear cover 280 and the second rear cover 290 may be substantially symmetrical in shape with respect to the folding axis A-A'. However, the first rear cover 280 and the second rear cover 290 are not necessarily symmetrical in shape. In another embodiment, the electronic device 101 may include the first rear cover 280 and the second rear cover 290 in various shapes. According to another embodiment, the first rear cover 280 may be integrally formed with the first housing structure 210, and the second rear cover 290 may be integrally formed with the second housing structure 220.

According to various embodiments, the first rear cover 280, the second rear cover 290, the first housing structure 210, and the second housing structure 220 may form a space where various components (e.g., a printed circuit board or battery) of the electronic device 101 may be disposed. According to an embodiment, one or more components may be arranged or visually exposed on/through the rear surface of the electronic device 101. For example, at least a portion of a sub display 200_1 may be visually exposed through the first rear cover 280. In another embodiment, one or more components or sensors may be visually exposed through the first rear cover 280. According to various embodiments, the sensor may include a proximity sensor and/or a rear-facing camera. Although not separately shown in the drawings, one or more other components or sensors may be visually exposed through the second rear cover 290.

According to various embodiments, the front camera 207 exposed from the front surface of the electronic device 101 through one or more openings or the rear camera 208 exposed through the first rear cover 280 may include one or more lenses, an image sensor, and/or an image signal processor. The flash 209 may include, e.g., a light emitting diode (LED) or a xenon lamp. According to an embodiment, two or more lenses (an infrared (IR) camera, a wide-angle lens, and a telephoto lens) and image sensors may be disposed on one surface of the electronic device 101.

FIG. 3 is an exploded perspective view illustrating an electronic device 101 according to various embodiments of the disclosure.

Referring to FIG. 3, according to various embodiments, an electronic device 101 may include a display 310 (e.g., the display 200 of FIG. 2), a foldable housing 320 (e.g., the foldable housing 200a of FIG. 2), a printed circuit board 330, a hinge structure 340, a flexible connection member 350, a hinge cover 360, an antenna structure 370, and a rear cover 380. Hereinafter, detailed descriptions of the components overlapping those of FIG. 2 (e.g., the display 310, the foldable housing 320, and the rear cover 380) will be omitted.

According to various embodiments, the display 310 may be exposed through a majority portion of the front plate 311. According to an embodiment, the shape of the display 310 may be formed to be substantially the same as the shape of the periphery of the front plate 311.

According to various embodiments, the foldable housing 320 may include a first housing 321 and a second housing 322. According to an embodiment, the first housing 321 may include a first surface 321a and a second surface 321b facing in a direction opposite to the first surface 321a. The second housing 322 may include a third surface 322a and a fourth surface 322b facing in a direction opposite to the third surface 322a. The foldable housing 320 may additionally or alternatively include a bracket assembly. The bracket assembly may include a first bracket assembly 323 disposed in the first housing 321 and a second bracket assembly 324 disposed in the second housing 322. At least part of the bracket assemblies, e.g., a portion 325 including at least part of the first bracket assembly 323 and at least part of the second bracket assembly 324, may serve as a plate for supporting the housing structure 340.

According to various embodiments, various electric components may be disposed on the printed circuit board 330. For example, a processor (e.g., the processor 120 of FIG. 1), a memory (e.g., the memory 130 of FIG. 1), and/or an interface (e.g., the interface 177 of FIG. 1) may be mounted on the printed circuit board 330. The processor may include one or more of, e.g., a central processing unit, an application processor, a graphic processing device, an image signal processing, a sensor hub processor, or a communication processor. The memory may include, e.g., a volatile or non-volatile memory. The interface may include, e.g., a high definition multimedia interface (HDMI), a universal serial bus (USB) interface, a secure digital (SD) card interface, and/or an audio interface. The interface may electrically or physically connect, e.g., the electronic device 300 with an external electronic device and may include a USB connector, an SD card/multimedia card (MMC) connector, or an audio connector.

According to various embodiments, the printed circuit board 330 may include a first printed circuit board 331 disposed on the side of the first bracket assembly 323 and a second printed circuit board 332 disposed on the side of the second bracket assembly 324. The first printed circuit board 331 and the second printed circuit board 332 may be disposed inside the space formed by the foldable housing 320, bracket assemblies, first rear cover 381 and/or second rear cover 382. Components for implementing various functions of the electronic device 101 may be separately disposed on the first printed circuit board 331 and the second printed circuit board 332. For example, a processor may be disposed on the first printed circuit board 331, and an audio interface may be disposed on the second printed circuit board 332.

According to various embodiments, a battery may be disposed adjacent to the printed circuit board 330 to supply power to the electronic device 101. At least a portion of the battery may be disposed on substantially the same plane as the printed circuit board 330. According to an embodiment, a first battery 333 may be disposed adjacent to the first printed circuit board 331, and a second battery 334 may be disposed adjacent to the second printed circuit board 332. The battery may be a device for supplying power to at least one component of the electronic device 101. The battery 189 may include, e.g., a primary cell which is not rechargeable, a secondary cell which is rechargeable, or a fuel cell. The battery may be integrally or detachably disposed inside the electronic device 101. According to various embodiments, the hinge structure 340 may be a component for supporting the foldable housing 320 and/or bracket assembly to allow the foldable housing to rotate about the folding axis (e.g., A-A' of FIG. 2). The hinge structure 340 may include a first hinge structure 341 disposed on the side of the first printed circuit board 331 and a second hinge structure 342 disposed on the side of the second printed circuit board 332. The hinge structure 340 may be disposed between the first printed circuit board 331 and the second printed circuit board 332. According to an embodiment, the hinge structure 340 may be formed substantially integrally with the portion 325 including at least a portion of the first bracket assembly 323 and at least a portion of the second bracket assembly 324.

According to various embodiments, a 'housing structure' may include the foldable housing 320 and may be one resultant from assembling and/or combining at least one component disposed in the housing 320. The housing structure may include a first housing structure and a second housing structure. For example, a component assembled to include the first housing 321 and further include at least one component among the first bracket assembly 323, the first printed circuit board 331, and the first battery 333 disposed inside the first housing 321 may be referred to as the 'first housing structure.' As another example, a component assembled to include the second housing 322 and further include at least one component among the second bracket assembly 324, the second printed circuit board 332, and the second battery 334 disposed inside the second housing 322 may be referred to as the 'second housing structure.' However, it should be noted that the 'first housing structure and the second housing structure' are not limited to the addition of the above-described components, but may add or omit various other components.

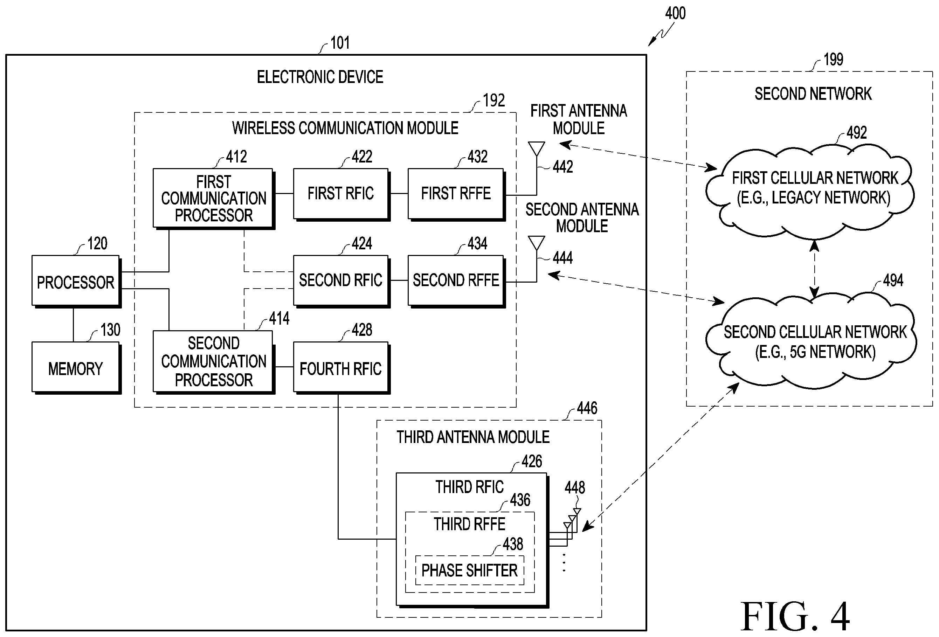

According to various embodiments, the flexible connection member 350 may be, e.g., a flexible printed circuit board (FPCB) and electrically connect various electrical elements disposed on the first printed circuit board 331 and the second printed circuit board 332. To this end, the flexible connection member 350 may be disposed to cross the 'first housing structure' and the 'second housing structure'. According to an embodiment, the flexible connection member 350 may be formed to at least partially hang over the hinge structure 340. According to an embodiment, the flexible connection member 350 may be configured to cross the hinge structure 340, e.g., in a direction parallel to the y-axis of FIG. 4 to connect the first printed circuit board 331 and the second printed circuit board 332. As another example, the flexible connection member 350 may be fitted into the openings 341h and 342h formed in the hinge structure 340. In this case, a portion 350a of the flexible connection member 350 may be disposed over one side (e.g., upper portion) of the first hinge structure 341, and another portion 350b of the flexible connection member 350 may be disposed over one side (e.g., upper portion) of the second hinge structure 342. Another portion 350c of the flexible connection member 350 may be disposed on the other side (e.g., lower portion) of the first hinge structure 341 and the second hinge structure 342. A space (hereinafter, referred to as a 'hinge space') surrounded by at least a portion of the first hinge structure 341, at least a portion of the second hinge structure 342, and at least a portion of the hinge cover 360 may be formed in a position adjacent to the first hinge structure 341 and the second hinge structure 342. According to an embodiment, at least a portion 350c of the flexible connection member 350 may be disposed in the hinge space.

According to various embodiments, the hinge cover 360 may be a component that covers at least a portion of the hinge space. The hinge cover 360, together with the hinge structure 340, may close the hinge space and protect a component (e.g., at least a portion 350c of the flexible connection member 350) disposed in the hinge space from external impact. According to an embodiment, the hinge cover 360 may be disposed between the first housing 321 and the second housing 322. According to an embodiment, the hinge cover 360 may be coupled to each of at least one portion of the first housing and at least one portion of the second housing.

According to various embodiments, the antenna structure 370 (e.g., the antenna module 197 of FIG. 1) may be disposed between the rear cover 380 and the battery. The antenna structure 370 may include a plurality of antenna modules in one electronic device 101. For example, the antenna structure 370 may include a first antenna module 371 disposed on the side of the first housing 321 and a second antenna module 372 disposed on the side of the second housing 322. The antenna module may include at least one radiator. Further, the antenna structure 370 may include, e.g., a near field communication (NFC) antenna, a wireless charging antenna, and/or a magnetic secure transmission (MST) antenna. The antenna structure 370 may perform short-range communication with an external device or wirelessly transmit/receive power required for charging. According to another embodiment, an antenna structure may be formed by a portion or combination of the side bezel structure of the foldable housing 320 and/or bracket assembly.

According to various embodiments, the rear cover 380 may include a first rear cover 381 and a second rear cover 382. The rear cover 380 may be combined with the foldable housing 320 to protect the above-described components (e.g., the printed circuit board 330, the battery, the flexible connection member 350, and the antenna structure 370) disposed in the foldable housing 320. As described above, the rear cover 380 may be configured substantially integrally with the foldable housing 320.

FIG. 4 is a block diagram 400 of an electronic device in a network environment including a plurality of cellular networks according to various embodiments.

Referring to FIG. 4, the electronic device 101 may include a first communication processor 412, a second communication processor 414, a first radio frequency integrated circuit (RFIC) 422, a second RFIC 424, a third RFIC 426, a fourth RFIC 428, a first radio frequency front end (RFFE) 432, a second RFFE 434, a first antenna module 442, a second antenna module 444, and an antenna 448. The electronic device 101 may further include a processor 120 and a memory 130. The second network 199 may include a first cellular network 492 and a second cellular network 494. According to another embodiment, the electronic device 101 may further include at least one component among the components of FIGS. 2 and 3, and the second network 199 may further include at least one other network. According to an embodiment, the first communication processor 412, the second communication processor 414, the first RFIC 422, the second RFIC 424, the fourth RFIC 428, the first RFFE 432, and the second RFFE 434 may form at least part of the wireless communication module 192. According to another embodiment, the fourth RFIC 428 may be omitted or be included as part of the third RFIC 426.

According to an embodiment, the first CP 412 may establish a communication channel of a band that is to be used for wireless communication with the first cellular network 492 or may support legacy network communication via the established communication channel. According to various embodiments, the first cellular network may be a legacy network that includes second generation (2G), third generation (3G), fourth generation (4G), or long-term evolution (LTE) networks. The second communication processor 414 may establish a communication channel corresponding to a designated band (e.g., from about 6GHz to about 60GHz) among bands that are to be used for wireless communication with the second cellular network 494 or may support fifth generation (5G) network communication via the established communication channel. According to an embodiment, the second cellular network 494 may be a 5G network defined by the 3rd generation partnership project (3GPP). Additionally, according to an embodiment, the first communication processor 412 or the second communication processor 414 may establish a communication channel corresponding to another designated band (e.g., about 6GHz or less) among the bands that are to be used for wireless communication with the second cellular network 494 or may support fifth generation (5G) network communication via the established communication channel. According to an embodiment, the first communication processor 412 and the second communication processor 414 may be implemented in a single chip or a single package. According to an embodiment, the first communication processor 412 or the second communication processor 414, along with the processor 120, an assistance processor 123, or communication module 190, may be formed in a single chip or single package.

According to an embodiment, the first CP 412 and the second CP 414 may be connected together directly or indirectly by an interface (not shown) to provide or receive data or control signals unilaterally or bi-laterally.

According to an embodiment, upon transmission, the first RFIC 422 may convert a baseband signal generated by the first CP 412 into a radio frequency (RF) signal with a frequency ranging from about 700MHz to about 3GHz which is used by the first cellular network 492 (e.g., a legacy network). Upon receipt, the RF signal may be obtained from the first cellular network 492 (e.g., a legacy network) through an antenna (e.g., the first antenna module 442) and be pre-processed via an RFFE (e.g., the first RFFE 432). The first RFIC 422 may convert the pre-processed RF signal into a baseband signal that may be processed by the first communication processor 412.

According to an embodiment, upon transmission, the second RFIC 424 may convert the baseband signal generated by the first communication processor 412 or the second communication processor 414 into a Sub6-band (e.g., about 6GHz or less) RF signal (hereinafter, "5G Sub6 RF signal") that is used by the second cellular network 494 (e.g., a 5G network). Upon receipt, the 5G Sub6 RF signal may be obtained from the second cellular network 494 (e.g., a 5G network) through an antenna (e.g., the second antenna module 444) and be pre-processed via an RFFE (e.g., the second RFFE 434). The second RFIC 424 may convert the pre-processed 5G Sub6 RF signal into a baseband signal that may be processed by a corresponding processor of the first communication processor 412 and the second communication processor 414.

According to an embodiment, the third RFIC 426 may convert the baseband signal generated by the second communication processor 414 into a 5G Above6 band (e.g., from about 6GHz to about 60GHz) RF signal (hereinafter, "5G Above6 RF signal") that is to be used by the second cellular network 494 (e.g., a 5G network). Upon receipt, the 5G Above6 RF signal may be obtained from the second cellular network 494 (e.g., a 5G network) through an antenna (e.g., the antenna 448) and be pre-processed via the third RFFE 436. The third RFIC 426 may convert the pre-processed 5G Above6 RF signal into a baseband signal that may be processed by the second communication processor 414. According to an embodiment, the third RFFE 436 may be formed as part of the third RFIC 426.

According to an embodiment, the electronic device 101 may include the fourth RFIC 428 separately from, or as at least part of, the third RFIC 426. In this case, the fourth RFIC 428 may convert the baseband signal generated by the second communication processor 414 into an intermediate frequency band (e.g., from about 9GHz to about 11GHz) RF signal (hereinafter, "IF signal") and transfer the IF signal to the third RFIC 426. The third RFIC 426 may convert the IF signal into a 5G Above6 RF signal. Upon receipt, the 5G Above6 RF signal may be received from the second cellular network 494 (e.g., a 5G network) through an antenna (e.g., the antenna 448) and be converted into an IF signal by the third RFIC 426. The fourth RFIC 428 may convert the IF signal into a baseband signal that may be processed by the second communication processor 414.

According to an embodiment, the first RFIC 422 and the second RFIC 424 may be implemented as at least part of a single chip or single package. According to an embodiment, the first RFFE 432 and the second RFFE 434 may be implemented as at least part of a single chip or single package. According to an embodiment, at least one of the first antenna module 442 or the second antenna module 444 may be omitted or be combined with another antenna module to process multi-band RF signals.

According to an embodiment, the third RFIC 426 and the antenna 448 may be disposed on the same substrate to form the third antenna module 446. For example, the wireless communication module 192 or the processor 120 may be disposed on a first substrate (e.g., a main painted circuit board (PCB)). In this case, the third RFIC 426 and the antenna 448, respectively, may be disposed on one area (e.g., the bottom) and another (e.g., the top) of a second substrate (e.g., a sub PCB) which is provided separately from the first substrate, forming the third antenna module 446. Placing the third RFIC 426 and the antenna 448 on the same substrate may shorten the length of the transmission line therebetween. This may reduce a loss (e.g., attenuation) of high-frequency band (e.g., from about 6GHz to about 60GHz) signal used for 5G network communication due to the transmission line. Thus, the electronic device 101 may enhance the communication quality with the second cellular network 494 (e.g., a 5G network).

According to an embodiment, the antenna 448 may be formed as an antenna array which includes a plurality of antenna radiators available for beamforming. In this case, the third RFIC 426 may include a plurality of phase shifters 438 corresponding to the plurality of antenna radiators, as part of the third RFFE 436. Upon transmission, the plurality of phase shifters 438 may change the phase of the 5G Above6 RF signal which is to be transmitted to the outside (e.g., a 5G network base station) of the electronic device 101 via their respective corresponding antenna radiators. Upon receipt, the plurality of phase shifters 438 may change the phase of the 5G Above6 RF signal received from the outside to the same or substantially the same phase via their respective corresponding antenna radiators. This enables transmission or reception via beamforming between the electronic device 101 and the outside.

According to an embodiment, the second cellular network 494 (e.g., a 5G network) may be operated independently (e.g., as standalone (SA)) from, or in connection (e.g., as non-standalone (NSA)) with the first cellular network 492 (e.g., a legacy network). For example, the 5G network may include access networks (e.g., 5G access networks (RANs)) but lack any core network (e.g., a next-generation core (NGC)). In this case, the electronic device 101, after accessing a 5G network access network, may access an external network (e.g., the Internet) under the control of the core network (e.g., the evolved **packet** core (EPC)) of the legacy network. Protocol information (e.g., LTE protocol information) for communication with the legacy network or protocol information (e.g., New Radio (NR) protocol information) for communication with the 5G network may be stored in the memory 430 and be accessed by other components (e.g., the processor 120, the first communication processor 412, or the second communication processor 414).

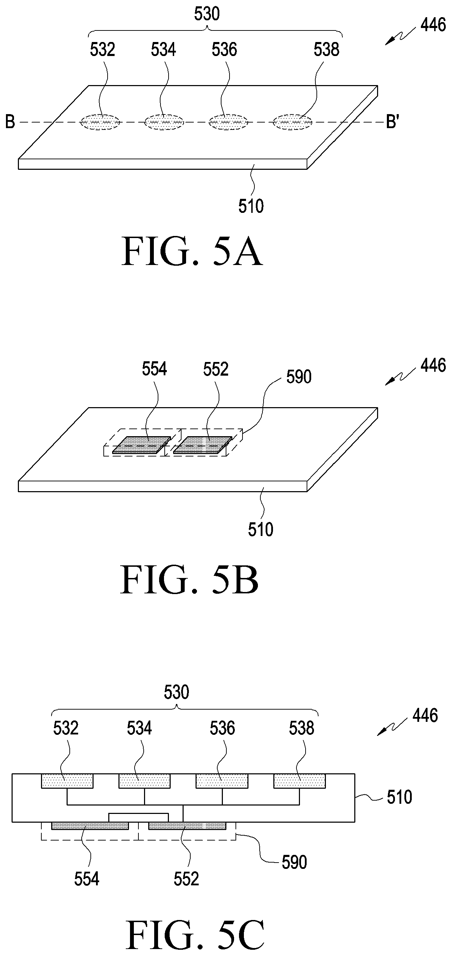

FIGS. 5A to 5C are views illustrating an embodiment of a structure of a third antenna module 446 described in connection with FIG. 4, according to various embodiments of the disclosure. FIG. 5A is a perspective view illustrating the third antenna module 446 viewed from one side, and FIG. 5B is a perspective view illustrating the third antenna module 446 viewed from another side. FIG. 5C is a cross-sectional view of the third antenna module 446, taken along line B-B'.

Referring to FIGS. 5A to 5C, according to an embodiment, the third antenna module 446 may include a printed circuit board 510, an antenna array 530, a radio frequency integrated circuit (RFIC) 552, and a power management integrated circuit (PMIC) 554. Selectively, the third antenna module 446 may further include a shielding member 590. According to other embodiments, at least one of the above-mentioned components may be omitted, or at least two of the components may be integrally formed with each other.

According to an embodiment, the printed circuit board 510 may include a plurality of conductive layers and a plurality of non-conductive layers alternately stacked with the conductive layers. Electronic components arranged on, or outside of, the printed circuit board 510 may be electrically connected together via wires and conductive vias formed on or through the conductive layers.

According to an embodiment, the antenna array 530 (e.g., the antenna 448 of FIG. 4) may include a plurality of antennas 532, 534, 536, or 538 arranged to form directional beams. The plurality of antennas may be formed on a first surface of the printed circuit board 510 as shown. According to another embodiment, the antenna array 530 may be formed inside the printed circuit board 510. According to embodiments, the antenna array 530 may include a plurality of antenna arrays (e.g., a dipole antenna array and/or a patch antenna array) of the same or different shapes or kinds.

According to an embodiment, the RFIC 552 (e.g., the third RFIC 426 of FIG. 4) may be disposed in another area (e.g., a second surface opposite to the first surface) of the printed circuit board 510 which is spaced apart from the antenna array. The RFIC is configured to be able to process signals of a selected frequency band which are transmitted or received via the antenna array 530. According to an embodiment, upon transmission, the RFIC 552 may convert a baseband signal obtained from a communication processor (not shown) into a designated band of RF signal. Upon receipt, the RFIC 552 may convert the RF signal received via the antenna array 552 into a baseband signal and transfer the baseband signal to the communication processor.

According to another embodiment, upon transmission, the RFIC 552 may up-convert an IF signal (e.g., ranging from about 9GHz to about 15GHz) obtained from the intermediate frequency integrated circuit (IFIC) into a selected band of RF signal. Upon receipt, the RFIC 552 may down-convert the RF signal obtained via the antenna array 530 into an IF signal and transfer the IF signal to the IFIC.

According to an embodiment, the PMIC 554 may be disposed in another portion (e.g., the second surface) of the PCB 510 which is spaced apart from the antenna array. The PMIC may receive a voltage from the main PCB (not shown) and provide necessary power to various components (e.g., the RFIC 552) on the antenna module.

According to an embodiment, the shielding member 590 may be disposed in a portion (e.g., the second surface) of the PCB 510 to electromagnetically shield off at least one of the RFIC 552 or the PMIC 554. According to an embodiment, the shielding member 590 may include a shield can.

Although not shown, according to various embodiments, the third antenna module 446 may be electrically connected with another printed circuit board (e.g., the main printed circuit board) via the module interface. The module interface may include a connecting member, e.g., a coaxial cable connector, board-to-board connector, interposer, or flexible printed circuit board (FPCB). The RFIC 552 and/or the PMIC 554 may be electrically connected with the printed circuit board via the connecting member.

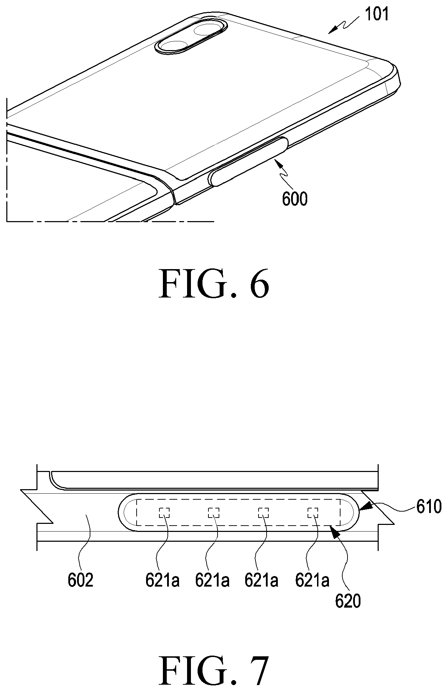

FIG. 6 is a perspective view illustrating a key assembly 600 (e.g., the key input devices 211, 212, and 213 of FIG. 2) of an electronic device 101 according to various embodiments of the disclosure. FIG. 7 is a see-through view of a key assembly 600 (e.g., the key input devices 211, 212, and 213 of FIG. 2) of an electronic device 101, as viewed from a side thereof, according to various embodiments of the disclosure.

According to various embodiments, an electronic device (e.g., the electronic device 101 of FIGS. 1 to 3) may include a housing (e.g., the foldable housing 200a of FIG. 2 or the foldable housing 320 of FIG. 3), a display (e.g., the display 200 of FIG. 2 or the display 310 of FIG. 3), a main circuit board (e.g., the printed circuit board 430 of FIG. 3), and a key assembly 600 (e.g., the key input devices 211, 212, and 213 of FIG. 2) electrically connected with the main circuit board.

According to various embodiments, the key assembly 600 may be disposed on a side surface of the electronic device 101 and at least partially exposed, and be pressed or touched by the user to transfer a signal to the inside of the electronic device 101. For example, the key assembly 600 may operate as a side key. As another example, the key assembly 600 may have a sensor module including a dome switch or a touch sensor module for transferring a signal when contacted by the user mounted therein to provide a click feeling when pressed by the user.

According to various embodiments, a portion of the key assembly 600, which extends along a side surface of the electronic device 101 (hereinafter, key case 610) may be exposed to the outside. When the electronic device 101 is viewed through a side surface thereof, an antenna structure 620 may be disposed in the key assembly 600. For example, the antenna structure 620 may be disposed in the electronic device 101 to face the key case 610 and may include a plurality of conductive plates 621a (e.g., the plurality of antennas 532, 534, 636 or 538 of FIG. 5A). The plurality of conductive plates 621a may be disposed at designated intervals, and may radiate electromagnetic waves to an area where the key case 610 formed of a non-conductive material is positioned.

In the electronic device according to an embodiment of the disclosure, as the antenna structure 620 is mounted in the outermost area of the electronic device 101 (e.g., an area adjacent to the key case 610), radiation performance may be enhanced. According to an embodiment of the disclosure, in the electronic device, the antenna structure 620 may be inserted in the key assembly 600, providing both antenna radiation and key operation.

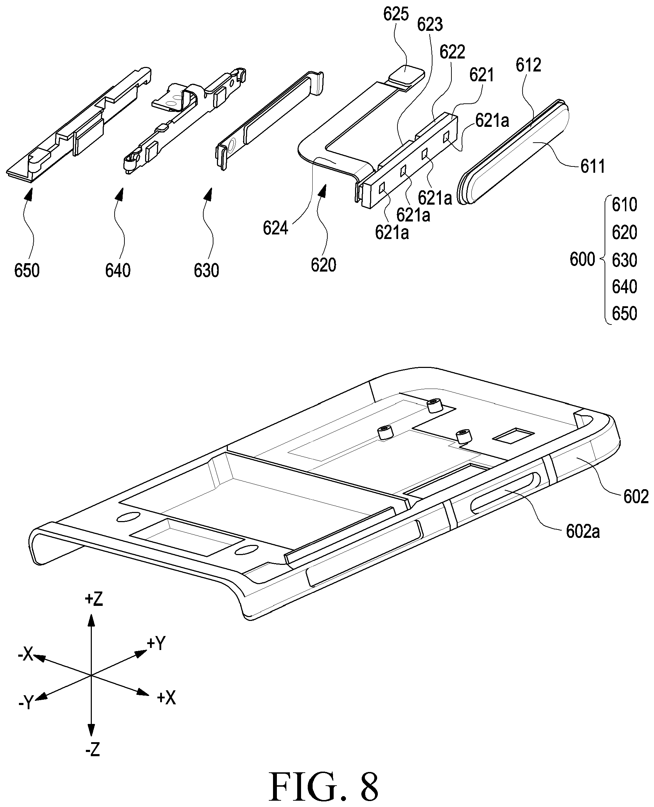

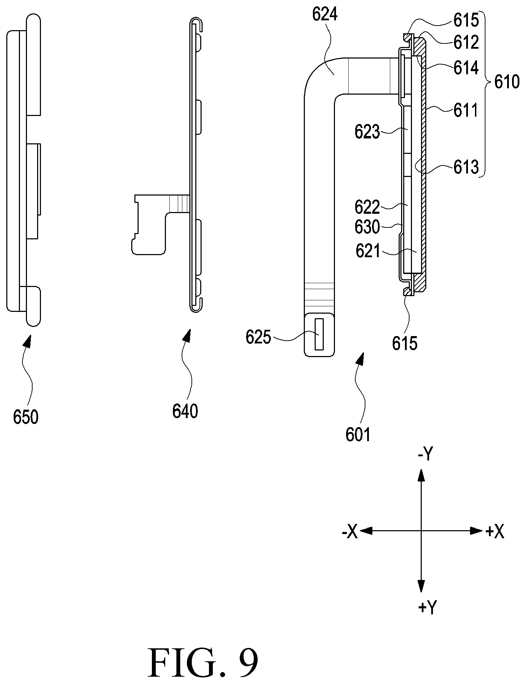

FIG. 8 is an exploded perspective view illustrating a key assembly 600 according to various embodiments of the disclosure. FIG. 9 is a top view illustrating a configuration in which components of a key assembly 600 are separated to install the key assembly 600 in an electronic device according to various embodiments of the disclosure.

According to various embodiments, an electronic device (e.g., the electronic device 101 of FIGS. 1 to 3) may include a housing 602 (e.g., the foldable housing 200a of FIG. 2 or the foldable housing 320 of FIG. 3), a display (e.g., the display 200 of FIG. 2 or the display 310 of FIG. 3), a main circuit board (e.g., the printed circuit board 430 of FIG. 3), and a key assembly 600 (e.g., the key input devices 211, 212, and 213 of FIG. 2) electrically connected with the main circuit board.

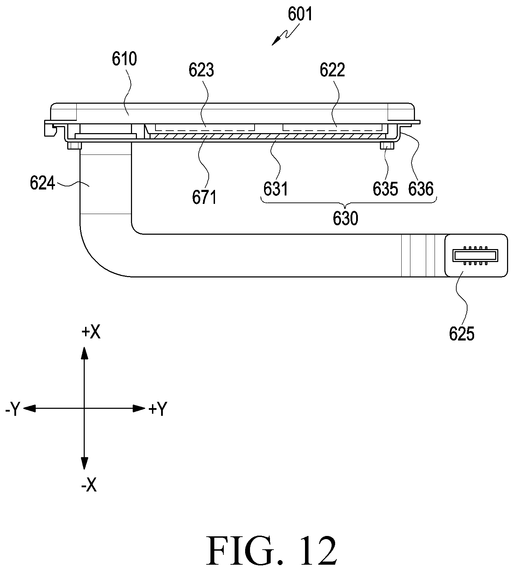

According to various embodiments, the key assembly 600 may include a key case (e.g., the key case 610 of FIG. 9), an antenna structure 620, a key circuit structure 640, a first bracket 630, and a second bracket 650. According to another embodiment, the key assembly 600 may include a key module (e.g., the key module 601 of FIG. 12), a key circuit structure 640, and a second bracket 650. For example, the key module 601 may be mounted in the housing 602 before the key case 610, the antenna structure 620, and the first bracket 630 in assembly are mounted in the electronic device, and the key circuit structure 640 and the second bracket 650 may then be sequentially assembled. Hereinafter, in the key assembly 600, the front direction may mean a direction (+X-axis direction) facing outward of the electronic device (or housing 602), and the rear direction may mean a direction (-X-axis direction) facing inward of the electronic device (or housing 602).

According to various embodiments, the housing 602 may include a first opening 602a passing through at least a portion of a side surface. The first opening 602a may be shaped as a hole for externally exposing at least a portion, e.g., the key case 610, of the key assembly 600 and be provided in a size corresponding to the key case 610. A recess (or stepped portion) which may be coupled with the key assembly 600 may be formed in the area adjacent to the first opening 602a of the housing 602. The key module 601 including the key case 610 may be inserted and disposed from the inside to outside of the housing 602, and the first opening 602a may be covered by the key case 610.

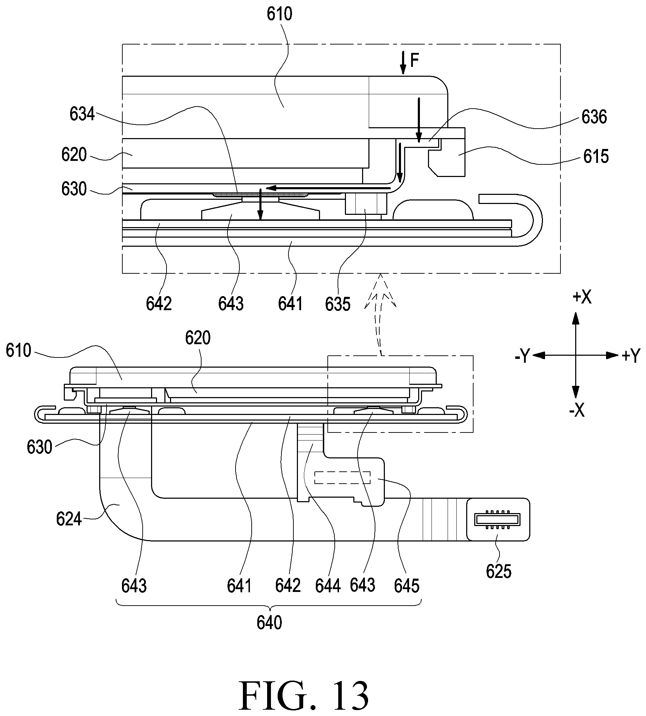

According to various embodiments, the main circuit board (not shown) (e.g., the printed circuit board 430 of FIG. 3) may be disposed in the housing 602, and at least a portion thereof may be disposed adjacent to the key assembly 600. In the key assembly 600, the circuit board (e.g., the antenna circuit board 621) of the antenna structure 620 and/or the circuit board (e.g., a key circuit board (e.g., the key circuit board 642 of FIG. 13)) of the key circuit structure 640 may be formed to extend in the rear direction (e.g., the internal direction (-X-axis direction)) of the key case 610 to electrically connect with the main circuit board. A connection member (e.g., the connection members 625 and 645 of FIG. 12) may be disposed in a partial area of the circuit board of the antenna structure 620 to electrically connect with the main circuit board. The connection members 625 and 645 may include one of a coaxial cable connector, a board-to-board connector, an interposer, or a flexible printed circuit board (FPCB).

According to an embodiment, the connection member 625 may be formed on each of the circuit board of the antenna structure 620 and the circuit board of the key circuit structure 640 to connect them to different portions of the main circuit board. According to another embodiment, the circuit board of the antenna structure 620 and the circuit board of the key circuit structure 640 may be integrated and extended as a single circuit board and be electrically connected to a portion of the main circuit board.

According to various embodiments, the key case 610 of the key assembly 600 may include an outer surface 611 exposed to the outside of the electronic device 101 and a side surface 612 extending to face in a direction (+Z-axis/-Z-axis direction) substantially perpendicular to the direction (+X-axis direction) in which the outer surface 611 faces and having at least a portion facing the housing 602. The key case 610 may further include an inner surface 613 facing in a direction (-X-axis direction) opposite to the outer surface 611 and an inner side surface 614 facing in a direction opposite to the side surface 612. The inner surface 613 and the inner side surface 614 may be provided in a recess shape to provide a space where the antenna structure 620 is mountable. According to another embodiment, the key case 610 may be overall shaped as "⊏" or "⊐".

According to an embodiment, the key case 610 may include first coupling portions 615 at two opposite ends thereof. The first coupling portion 615 is a portion for coupling with the first bracket 630 and be designed in various manners. For example, the first coupling portion 615 may be manufactured in a hook shape including a recess. The second coupling portion 636 of the first bracket 630 may be fitted into the recess.

According to an embodiment, the key case 610 may be overall formed of a non-metallic material. For example, the key case 610 may include a non-metallic material, such as an injection-molded article or ceramic. As the conductive plates 621a of the antenna structure 620 disposed inside the key case 610 are disposed to contact the inner surface 613 of the key case 610, the number of media through which electromagnetic waves pass may be reduced, and radiation performance may be enhanced thanks to the non-metallic media.

According to various embodiments, the antenna structure 620 of the key assembly 600 may include an antenna circuit board 621, conductive plates 621a, a radio frequency integrated circuit (RFIC) 622, and a power management integrated circuit (PMIC) 623. The configuration of the antenna module 446 of FIGS. 4 and 5 may be applied to a specific configuration of the antenna structure 620.

According to an embodiment, the plurality of conductive plates 621a forming an antenna array may be arranged toward the key case 610, and the RFIC 622 and the PMIC 623 may be disposed toward the first bracket 630. The antenna circuit board 621 may include a flexible area 624, and the flexible area 624 may extend through a gap formed between the key case 610 and the first bracket 630 in the internal direction (-X-axis direction) of the electronic device 101. The connection member 625 may be disposed at an end portion of the flexible area 624 to connect with the main circuit board. For example, the RFIC 622 and/or PMIC 623 of the antenna structure 620 may be electrically connected with the main circuit board through the connection member 625.

According to various embodiments, the first bracket 630 of the key assembly 600 may be disposed on the rear surface of the key case 610 and the antenna structure 620 to support the key case 610 and the antenna structure 620.

According to various embodiments, the key circuit structure 640 of the key assembly 600 is a structure for performing a key operation and may be disposed to face the antenna structure 620 with the first bracket 630 disposed therebetween. The second bracket 650 of the key assembly 600 may cover the rear surface of the key assembly 600 and, together with the first bracket 630, overall support the key assembly 600 and provide a space for receiving the key circuit structure 640. The components (the first bracket 630, the key circuit structure 640, and the second bracket 650) of the key assembly are described below in detail.

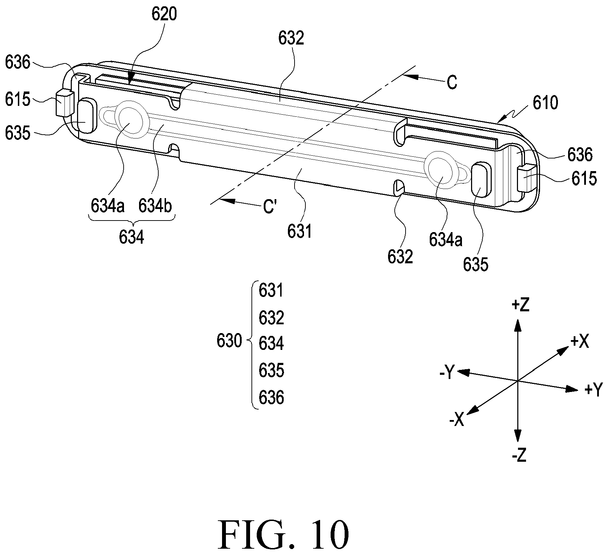

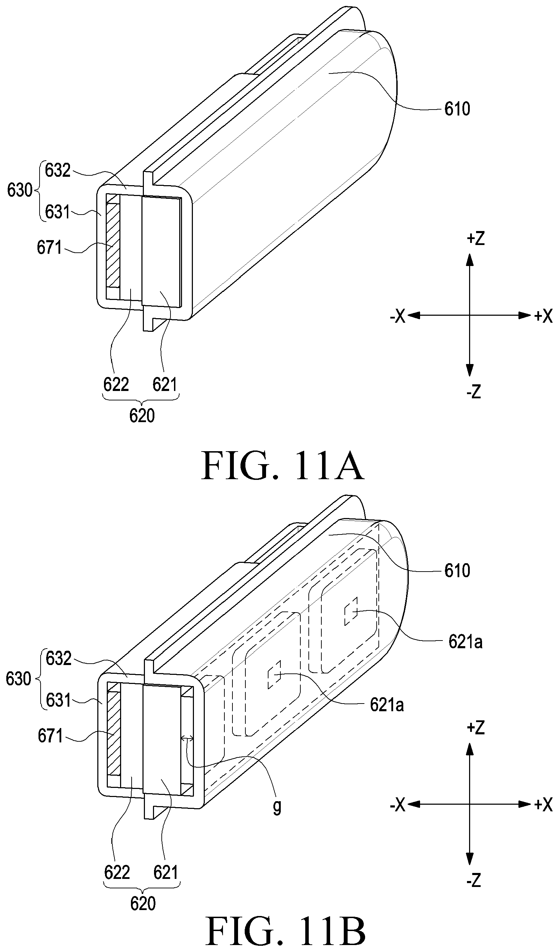

FIG. 10 is a perspective view illustrating a state in which a key case 610 of a key assembly 600, an antenna structure 620, and a first bracket 630 are assembled according to various embodiments of the disclosure. FIGS. 11A and 11B are cross-sectional views taken along C-C' of the key assembly 600 of FIG. 8, according to various embodiments of the disclosure. FIG. 12 is a top view illustrating a state in which a key case 610 of a key assembly 600, an antenna structure 620, a first bracket 630, and a key circuit unit 640 are assembled according to various embodiments of the disclosure.

According to various embodiments, an electronic device (e.g., the electronic device 101 of FIGS. 1 to 3) may include a housing (e.g., the foldable housing 200a of FIG. 2 or the foldable housing 320 of FIG. 3), a display (e.g., the display 200 of FIG. 2 or the display 310 of FIG. 3), a main circuit board (e.g., the printed circuit board 430 of FIG. 3), and a key assembly 600 (e.g., the key input devices 211, 212, and 213 of FIG. 2) electrically connected with the main circuit board.

The structure of the key assembly 600 of FIGS. 10 to 12 may be the same in whole or part as the structure of the key assembly 600 of FIGS. 8 and 9.

According to various embodiments, in the key assembly 600, the key case 610, the antenna structure 620, and the first bracket 630 may be sequentially coupled, forming a key module 601. For example, the key case 610 and the first bracket 630 may be at least partially coupled together, providing an internal space where the antenna structure 620 may be mounted. As another example, referring to FIGS. 11A and 11B, the cross section of a center area of the key module 601 may represent a structure in which the key case 610, the antenna structure 620, and the first bracket 630 are sequentially stacked, and the cross section of an edge portion of the key module 601 may maintain the state in which the key case 610 and the first bracket 630 contact each other.

According to various embodiments, the key case 610 may be exposed outward (+X-axis direction) of the electronic device 101 and, together with the first bracket 630, provide a space for receiving the antenna structure 620.

According to various embodiments, referring to FIG. 11A, the first bracket 630 may be disposed on the rear surface of the key case 610 to support the antenna structure 620. The first bracket 630 and the key case 610 are disposed in contact with the antenna structure 620, fixing the antenna structure 620. According to an embodiment, referring to FIG. 11B, the first bracket 630 and/or the key case 610 may be spaced apart from at least a portion of the antenna structure 620. For example, the antenna circuit board 621 of the antenna structure 620 and/or the plurality of conductive plates 621a arranged on the antenna circuit board 621 may be spaced apart from the key case 610 by a designated gap g.

According to various embodiments, the first bracket 630 may absorb the impact caused when a key clicks and dissipate the heat generated from the antenna structure. According to an embodiment, the first bracket 630 may include a base portion 631 overall supporting the antenna structure 620, a supporting portion 632 protruding in the front direction (+X-axis direction) toward the key case 610 to be disposed in contact with the key case 610, and an actuator portion 634 formed on the rear surface of the base portion 631. The first bracket 630 may further include an elastic portion 635 disposed adjacent to the actuator portion 634 and a second coupling portion 636 for coupling with the key case 610.

According to an embodiment, the first bracket 630 may be overall formed of a metallic material. According to an embodiment, in the first bracket 630, the actuator portion 634 may be formed of a non-metallic material, and the remaining portions may be formed of a metallic material.

According to an embodiment, the base portion 631 of the first bracket 630 has a plate shape and may be disposed to face the inner surface 613 of the key case 610. The base portion 631 may provide one surface on which the antenna structure 620 may be seated and may dissipate the heat generated from the antenna structure 620. For example, the base portion 631 may be disposed in contact with the antenna structure 620. As another example, a first heat dissipation sheet 671 may be disposed on one surface of the base portion 631, and the antenna structure 620 may be disposed on the first heat dissipation sheet 671.

According to an embodiment, the supporting portion 632 of the first bracket 630 may be formed to extend from the edge of the base portion 631 in the front direction (+X-axis direction), and an end thereof may be disposed in contact with the side surface 612 of the key case 610. The supporting portion 632 may directly receive the force (or impact) transferred from the key case 610 to protect the antenna structure 620 positioned therein. Referring to FIGS. 11A and 11B, the cross sections of the base portion 631 and the supporting portion 632 may be configured in a form corresponding to the cross section of the key case 610. For example, if the key case 610 is shaped as " ⊐," the cross sections of the base portion 631 and the supporting portion 632 may be provided in a "⊏" shape.

According to an embodiment, the actuator portion 634 of the first bracket 630 may be formed to protrude from one surface of the base portion 631 in the rear direction (-X-axis direction), and at least a portion thereof may be formed to face a dome switch (e.g., the dome switch 643 of FIG. 13) disposed on the key circuit structure 640. The actuator portion 634 may be provided overall in a beading shape for rigidity. For example, the actuator portion 634 may include a first portion 634a and a second portion 634b. The first portion 634a may be manufactured in a shape (e.g., circular shape) corresponding to the dome switch 643 for key operation, and the second portion 634b, which is shaped as a line for rigidity, may be protruded therearound. As another example, when a plurality of dome switches 643 are formed, a plurality of first portions 634a of the actuator portion 634 may be provided corresponding thereto, and a second portion 634b for rigidity may be extended between the plurality of first portions 634a. According to an embodiment, the actuator portion 634 may be formed of a non-metallic material, preventing damage or wear of the dome switch 643.

According to an embodiment, the elastic portion 635 of the first bracket 630 may be formed to protrude from one surface of the base portion 631 in the rear direction (-X-axis direction) and may be formed adjacent to the dome switch 643. For example, the elastic portion 635 may be positioned around the first portion 634a of the actuator portion 634 and may prevent damage to the dome switch 643 due to the elastic member protruding beyond the first portion 634a in the rear direction (-X-axis direction). As another example, when a plurality of dome switches 643 are formed, a plurality of first portions 634a of the actuator portion 634 may be provided corresponding thereto, and a plurality of elastic portions 635 may be disposed adjacent to the first portions 634a.

According to an embodiment, the second coupling portion 636 of the first bracket 630 may be formed to extend from the edge of the base portion 631 in the length direction (+Y-axis/-Y-axis direction), and an end thereof may include a step shape and be coupled with the first coupling portion 615 of the key case 610. For example, the second coupling portion 636 may be provided in a plate shape and may be fitted into the recess formed in the first coupling portion 615.

FIG. 13 is a top view illustrating a state in which a key case 610 of a key assembly 600, an antenna structure 620, a first bracket 630, and a key circuit structure 640 are assembled according to various embodiments of the disclosure.

According to various embodiments, an electronic device (e.g., the electronic device 101 of FIGS. 1 to 3) may include a housing 602 (e.g., the foldable housing 200a of FIG. 2 or the foldable housing 320 of FIG. 3), a display (e.g., the display 200 of FIG. 2 or the display 310 of FIG. 3), a main circuit board (e.g., the printed circuit board 430 of FIG. 3), and a key assembly 600 (e.g., the key input devices 211, 212, and 213 of FIG. 2) electrically connected with the main circuit board.

The structure of the key assembly 600 of FIG. 13 may be the same in whole or part as the structure of the key assembly 600 of FIGS. 9 to 12.

According to various embodiments, in the key assembly 600, the key circuit structure 640 may be assembled to face the surface which faces in the rear direction (-X-axis direction) of the first bracket 630, in the key module 601 (e.g., the key case 610, the antenna structure 620, and the first bracket 630).

According to various embodiments, the key circuit structure 640 may include a flexible area 644 extending from an end portion of the key circuit board 642 toward the inside (-X-axis direction) of the electronic device 101.

According to an embodiment, the base member 641 may support the key circuit board 642 and may have two opposite ends to surround at least a portion of the key circuit board 642 to protect the key circuit board 642. The dome switch 643 may provide a dome shape protruding in the front direction (+X-axis direction) and be positioned to face the actuator portion 634 of the first bracket 630. The connection member 645 may be disposed at an end portion of the flexible area 644 to connect with the main circuit board.

According to an embodiment, the force transferred from the key case 610 may be stably provided to the key circuit structure 640 via the first bracket 630. For example, the pressure F applied to the end area of the key case 610 may be transferred to the end portion (e.g., the second coupling portion 636) of the first bracket 630 coupled to the key case 610. The transferred pressure may be transferred to the dome switch 643 via the actuator portion 634 of the first bracket 630. The elastic portion 635 of the first bracket 630 may be disposed around the dome switch 643 and be disposed to protrude along the moving direction (e.g., +X/-X-axis direction) of the dome switch 643. Accordingly, it is possible to prevent the dome switch 643 from being subjected to a certain level of shock or more. According to an embodiment, if the dome switch 643 is partially elastically deformed to provide the transferred pressure to the key circuit board 642, an electrical signal corresponding to the pressure may be generated and be transferred through the flexible area 644 to the main circuit board of the electronic device 101.

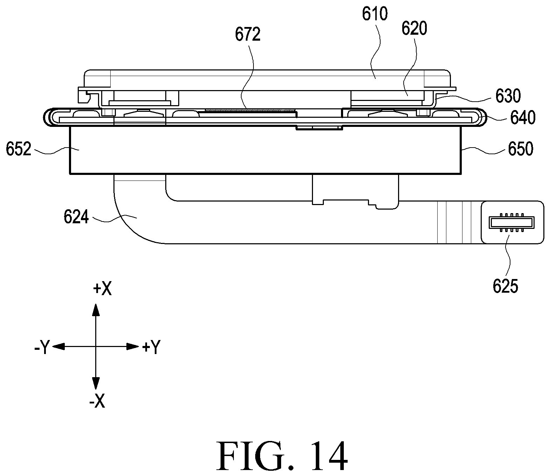

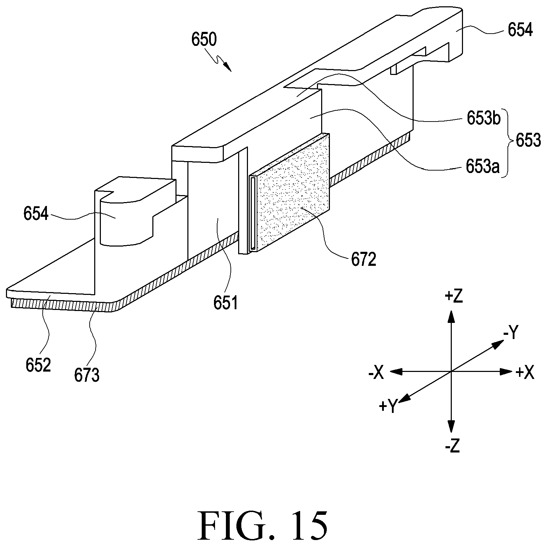

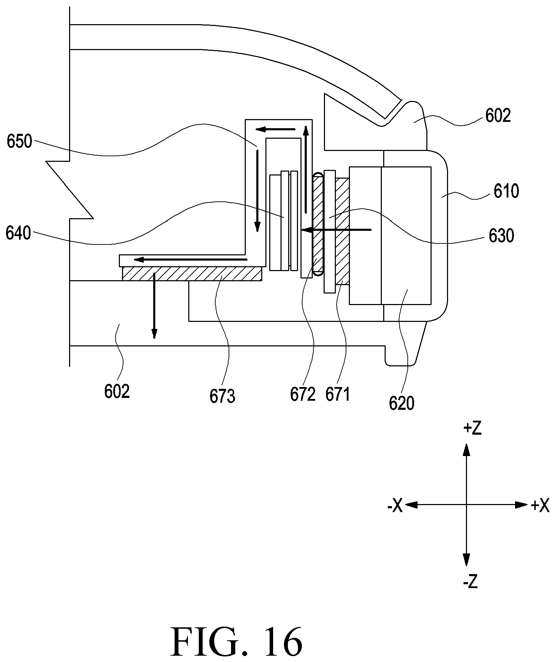

FIG. 14 is a see-through view of an assembled state of a key case 610 of a key assembly 600, an antenna structure 620, a first bracket 630, a key circuit structure 640, and a second bracket 650, as viewed from the top, according to various embodiments of the disclosure. FIG. 15 is a perspective view illustrating a structure of a second bracket 650 of a key assembly 600 according to various embodiments of the disclosure. FIG. 16 is a view illustrating a thermal conduction path of a key assembly 600 according to various embodiments of the disclosure.

According to various embodiments, an electronic device (e.g., the electronic device 101 of FIGS. 1 to 3) may include a housing 602 (e.g., the foldable housing 200a of FIG. 2 or the foldable housing 320 of FIG. 3), a display (e.g., the display 200 of FIG. 2 or the display 310 of FIG. 3), a main circuit board (e.g., the printed circuit board 430 of FIG. 3), and a key assembly 600 (e.g., the key input devices 211, 212, and 213 of FIG. 2) electrically connected with the main circuit board.

The structure of the key assembly 600 of FIGS. 14 to 16 may be the same in whole or part as the structure of the key assembly 600 of FIGS. 8 to 13.

According to various embodiments, in the key assembly 600, the second bracket 650 may be assembled after the key circuit structure 640 is assembled to the first bracket 630 in the key module 601 (e.g., the key case 610, the antenna structure 620, and the first bracket 630).

According to various embodiments, the second bracket 650 may be disposed on the rear surface (-X-axis direction) of the first bracket 630 and support the key circuit structure 640. The second bracket 650 may transfer the heat transferred from the antenna structure 620 to the first bracket 630 to the housing 602 (e.g., the housing 602 of FIG. 8) of the electronic device. According to an embodiment, the second bracket 650 may include a first supporting area 651 that overall supports the key circuit structure 640, a second supporting area 652 seated on the housing 602 of the electronic device, and a third supporting area 653 that is disposed to face the first supporting area 651 and connected with the first supporting area 651 to provide a space for receiving the key circuit structure 640. The second bracket 650 may further include a protrusion 654 protruding from an end portion of the first supporting area 651 to couple with the housing 602 near the first opening (e.g., the first opening 602a of FIG. 8).

According to various embodiments, the second bracket 650 may be overall formed of a metallic material. According to an embodiment, the first supporting area 651 of the second bracket 650 has a plate shape and may be disposed to face the rear surface (-X-axis direction) of the key circuit structure 640. The third supporting area 653 of the second bracket 650 may be formed to extend from the upper end portion of the first supporting area 651 and include a first portion (e.g., a portion facing in the +Z-axis direction) 653b facing upward and a second portion (e.g., a portion facing in the +X-axis direction) 653a facing the key circuit structure 640. For example, the second bracket 650 may be provided in an "L" shape, and the first supporting area 651 and the third supporting area 653 together may provide a space for receiving the key circuit structure 640. One surface of the first portion 653a of the third supporting area 653 facing the key circuit structure 640 may have a smaller area than the first supporting area 651, and may seat the second heat dissipation sheet 672 thereon. For example, the second heat dissipation sheet 672 may include at least one of graphite, carbon nanotubes, natural regenerated materials, silicone, silicon, or graphite. As another example, the second heat dissipation sheet 672 may include at least one of a sponge, a copper (Cu) plate, a heat pipe, or a vapor chamber.

According to an embodiment, the second supporting area 652 of the second bracket 650 may have a plate shape and be disposed substantially perpendicular to the first supporting area 651 and may be disposed to face the housing 602 of the electronic device. The second supporting area 652 may overall support the second bracket 650, and its surface facing downward (the surface facing in the -Z-axis direction) may seat the third heat dissipation sheet 673 thereon. For example, the third heat dissipation sheet 673 may include at least one of graphite, carbon nanotubes, natural regenerated materials, silicone, silicon, or graphite. As another example, the third heat dissipation sheet 673 may include at least one of a sponge, a copper (Cu) plate, a heat pipe, and a vapor chamber.

According to an embodiment, the protrusion 654 of the second bracket 650 may be formed to protrude from the upper end portion of the first supporting area 651 and extend in two opposite directions. The protrusion 654 may be disposed in parallel with the upward facing surface (the surface facing in the +Z-axis direction) 653b of the third supporting area 653 and be coupled with the housing 602, fixing the second bracket 650 as a whole.

Referring to FIG. 16, the heat generated from the antenna structure 620 may diffuse to the housing 602 via the key assembly 600. For example, the heat generated from the antenna structure 620 may be transferred to the first heat dissipation sheet 671 and the first bracket 630 stacked on the rear surface (the side facing in the -X-axis direction) of the antenna structure 620. The transferred heat may be transferred to the second bracket 650 via the second heat dissipation sheet 672 disposed to face the first bracket 630. The second bracket 650 may be formed so that one surface thereof faces the first bracket 630, and the other surface faces the housing 602. The third heat dissipation sheet 673 may be attached between the other surface of the second bracket 650 and the housing 602, easily diffusing the heat transferred to the second bracket 650 to the housing.

However, the configuration of the key assembly and the heat dissipation sheets for the heat transfer path is not limited to the present embodiment, but the design may be changed in other various forms, such as connecting the second heat dissipation sheet 672 and the third heat dissipation sheet 673 to one sheet to provide a path for directly transferring heat to the housing 602.

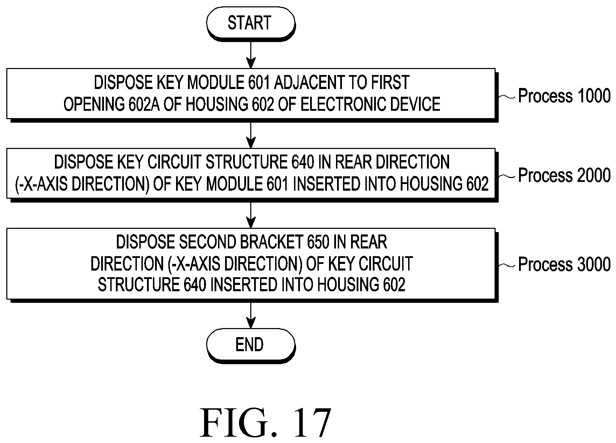

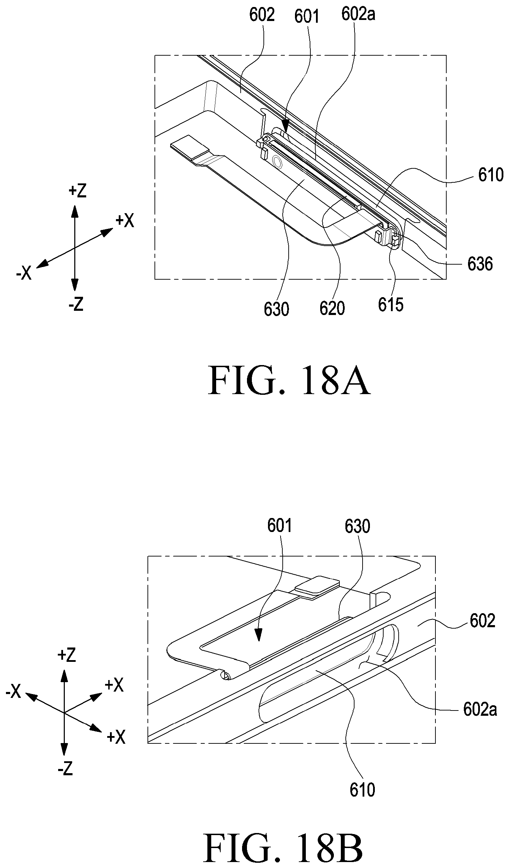

FIG. 17 is a flowchart illustrating an order of assembling a key assembly 600 according to various embodiments of the disclosure. FIGS. 18A to 18E are schematically illustrating an order of assembling a key assembly 600 according to various embodiments of the disclosure.

According to various embodiments, an electronic device (e.g., the electronic device 101 of FIGS. 1 to 3) may include a housing 602 (e.g., the foldable housing 200a of FIG. 2 or the foldable housing 320 of FIG. 3), a display (e.g., the display 200 of FIG. 2 or the display 310 of FIG. 3), a main circuit board (e.g., the printed circuit board 430 of FIG. 3), and a key assembly 600 (e.g., the key input devices 211, 212, and 213 of FIG. 2) electrically connected with the main circuit board.

The structure of the key assembly 600 of FIGS. 17 and 18A to 18E may be the same in whole or part as the structure of the key assembly 600 of FIGS. 8 to 16.

According to various embodiments, according to process 1000 (e.g., FIGS. 18A and 18B), the key assembly 600 may be disposed within the housing 602 of the electronic device after forming the key module 601. For example, the key module 601 may be pre-assembled before being mounted in the housing 602 in a state in which the key case 610, the antenna structure 620, and the first bracket 630 are assembled. Of the key case 610, the antenna structure 620, and the first bracket 630, the antenna structure 620 and the first bracket 630 may be sequentially assembled along the rear direction (-Z-axis direction) with respect to the key case 610. The second coupling portion 636 of the first bracket 630 may be inserted and fixed into the recess formed in the first coupling portion 615 of the key case 610.

Then, the key module 601 may be assembled adjacent to the first opening 602a of the housing 602. A portion of the key case 610 may be disposed to pass through the first opening 602a and be exposed to the outside. As the antenna structure 620 disposed in the inner mounting space of the key case 610 is mounted in the outermost area of the electronic device, enhanced radiation performance may be provided.

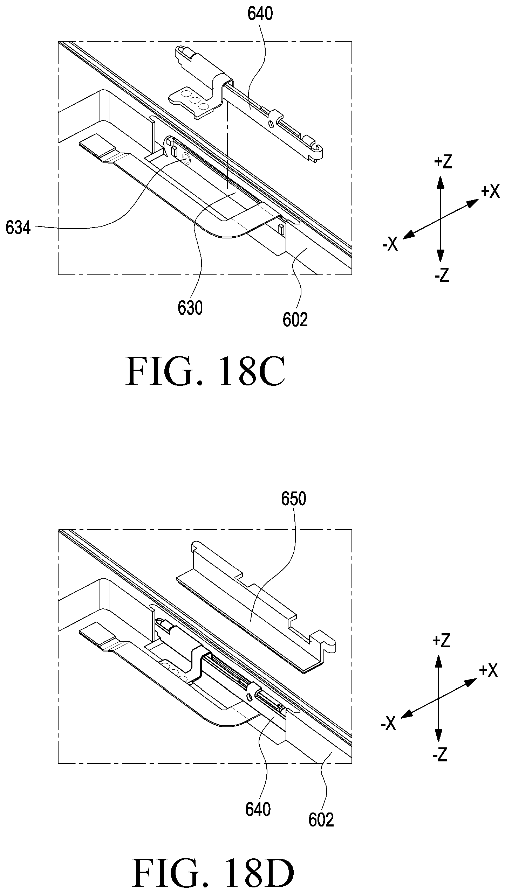

According to various embodiments, according to process 2000 (e.g., FIG. 18C), the key circuit structure 640 may be disposed in the rear direction (-X-axis direction) of the key module 601 inserted into the housing 602. The key circuit structure 640 may include a dome switch (e.g., the dome switch 643 of FIG. 13) and be disposed so that the dome switch 643 faces the actuator portion 634 of the first bracket 630.

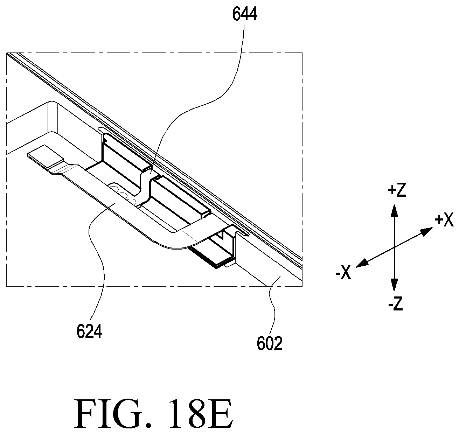

According to various embodiments, according to process 3000 (e.g., FIGS. 18D and 18E), the second bracket 650 may be disposed in the rear direction (-X-axis direction) of the key circuit structure 640 inserted into the housing 602. The second bracket 650 may be formed to surround at least a portion of the key circuit structure 640 to support and protect the key circuit structure 640. Accordingly, when the second bracket 650 is assembled, the entire key circuit structure 640 may be covered and be prevented from damage by external impact. At least one opening may be formed in one side of the second bracket 650, allowing the flexible area 624 of the antenna circuit board of the antenna structure 620 and/or the flexible area 644 of the key circuit board of the key circuit structure 640 to be disposed therethrough to be connected to the main circuit board.

According to an embodiment, the second bracket 650 may be connected to a portion of the housing 602, and a heat radiation sheet may be disposed on each of the first bracket 630 and the second bracket 650. As the components (e.g., the antenna structure 620, the first bracket 630, and the second bracket 650) of the key assembly 600 are disposed in contact with each other through the heat dissipation sheets, the heat generated from the antenna structure 620 may easily be diffused.

According to various embodiments of the disclosure, an electronic device (e.g., the electronic device 101 of FIGS. 1 to 3) may comprise a housing (e.g., the housing 602 of FIG. 8) including a first opening (e.g., the first opening 602a of FIG. 8), a key case (e.g., the key case 610 of FIG. 8) including an outer surface (e.g., the outer surface 611 of FIG. 8) formed to face in a first direction (e.g., the +X-axis direction of FIG. 8) to cover the first opening and a recess formed to face in a second direction (e.g., the -X-axis direction of FIG. 8) opposite to the first direction, an antenna structure (e.g., the antenna structure 620 of FIG. 8) seated in the recess of the key case and including an array of a plurality of conductive plates (e.g., the conductive plates 621a of FIG. 8) facing in the first direction, a key circuit structure (e.g., the key circuit structure 640 of FIG. 8) for a key operation, disposed in the second direction of the antenna structure, a first bracket (e.g., the first bracket 630 of FIG. 8) formed to surround at least a portion of the antenna structure and disposed between the antenna structure and the key circuit structure, and a second bracket (e.g., the second bracket 650 of FIG. 8) supporting the key circuit structure and including a first portion (e.g., the first portion 653a of the third supporting area 653 of FIG. 15) formed to face the antenna structure and a second portion (e.g., the second supporting area 652 of FIG. 15) disposed in a direction different from the first portion and formed to face an inner area of the housing.

According to various embodiments, at least a portion of the key case facing in a direction in which the plurality of conductive plates face may be formed of a non-metallic material.

According to various embodiments, the electronic device may further comprise a first heat dissipation sheet (e.g., the first heat dissipation sheet 671 of FIG. 11A) disposed between the antenna structure and the first bracket.

According to various embodiments, the electronic device may further comprise a second heat dissipation sheet (e.g., the second heat dissipation sheet 672 of FIG. 15) disposed on the first portion of the second bracket to contact the first bracket and a third heat dissipation sheet (e.g., the third heat dissipation sheet 673 of FIG. 15) disposed on the second portion of the second bracket to contact the inner area of the housing.

According to various embodiments, heat generated from the antenna structure may be diffused through the first heat dissipation sheet and the first bracket to the second heat dissipation sheet, the second bracket, and the third heat dissipation sheet to be transferred to the inner area of the housing.

According to various embodiments, at least one of the first heat dissipation sheet, the second heat dissipation sheet, or the third heat dissipation sheet may include at least one material among carbon nanotubes, a natural regenerated material, silicone, silicon, or graphite.

According to various embodiments, the key case may include a side surface (e.g., the side surface 612 of FIG. 9) formed along an edge to form the recess and a first coupling portion (e.g., the first coupling portion 615 of FIG. 9) disposed adjacent to the side surface to couple with the first bracket.

According to various embodiments, the antenna structure may include an antenna circuit board (e.g., the antenna circuit board 621 of FIG. 11A), the plurality of conductive plates disposed on one surface of the antenna circuit board facing in the first direction, and a wireless communication circuit disposed on one surface of the antenna circuit board facing in the second direction, electrically connected with the plurality of conductive plates, and configured to transmit and/or receive a radio frequency (RF) signal.

According to various embodiments, the antenna structure may transmit and/or receive a signal having a designated frequency band ranging from 6GHz to 300GHz through the plurality of conductive plates.

According to various embodiments, the first bracket may include a base portion (e.g., the base portion 631 of FIG. 10) overall supporting the antenna structure, a supporting portion (e.g., the supporting portion 632 of FIG. 10) protruding toward the key case to be disposed in contact with an edge area of the key case, and an actuator portion (e.g., the actuator portion 634 of FIG. 10) formed on a surface of the base portion facing in the second direction.

According to various embodiments, the actuator portion of the first bracket may include a first area (e.g., the first portion 634a of FIG. 10) provided in a shape corresponding to a dome switch of the key circuit structure for the key operation and a second area (e.g., the second portion 634b of FIG. 10) disposed adjacent to the first area and formed to have a line shape to provide rigidity of the actuator portion.

According to various embodiments, the first bracket further may include an elastic portion (e.g., the elastic portion 635 of FIG. 10) disposed adjacent to the actuator portion to prevent impact caused when the actuator portion contacts the dome switch of the key circuit structure and a second coupling portion (e.g., the second coupling portion of FIG. 10) for coupling with the key case.

According to various embodiments, the key circuit structure may include a key circuit board (e.g., the key circuit board 642 of FIG. 13), a base member (e.g., the base member 641 of FIG. 13) supporting the key circuit board and having two opposite end portions formed to surround at least a portion of the key circuit board and a dome switch (e.g., the dome switch 643 of FIG. 13) disposed on the key circuit board.

According to various embodiments, the second bracket may include a first supporting area (e.g., the first supporting area 651 of FIG. 15) overall supporting the key circuit structure and a second supporting area (e.g., the third supporting area 653 of FIG. 15) connected with the first supporting area to provide a space for receiving the key circuit structure.

According to various embodiments, the second supporting area (e.g., the third supporting area 653 of FIG. 15) of the second bracket may be disposed to face the first supporting area and include the first portion (e.g., the first portion 653a of FIG. 15) forming one surface in a smaller area than the second supporting area and a second portion (e.g., the second portion 653b of FIG. 15) extending from an upper end portion of the first supporting area and formed in a third direction perpendicular to the first direction.

According to various embodiments, the second bracket may be formed of a metallic material and further include a protrusion (e.g., the protrusion 654 of FIG. 15) formed to protrude from an end portion of the first supporting area to couple with a portion of the housing near the first opening.

According to various embodiments, the plurality of conductive plates of the antenna structure may transmit or receive high-frequency signals through a radiation area, and the radiation area may include a portion of a key case formed of a non-metallic material.

According to various embodiments of the disclosure, a key assembly (e.g., the key assembly 600 of FIG. 8) may comprise a key case (e.g., the key case 610 of FIG. 8) including an outer surface formed to be exposed on a side of an electronic device and a recess formed to face in a second direction opposite to a first direction in which the outer surface faces, an antenna structure (e.g., the antenna structure 620 of FIG. 8) seated in the recess of the key case and including an array of a plurality of conductive plates facing in the first direction, a key circuit structure (e.g., the key circuit structure 640 of FIG. 8) for a key operation, disposed in the second direction of the antenna structure, a first bracket (e.g., the first bracket 630 of FIG. 8) formed to surround at least a portion of the antenna structure and disposed between the antenna structure and the key circuit structure, and a second bracket (e.g., the second bracket 650 of FIG. 8) supporting the key circuit structure, formed to be connected while surrounding at least a portion of the key circuit structure to provide a path for passage of heat generated from the antenna structure, and disposed to face the first bracket.

According to various embodiments, the plurality of conductive plates of the antenna structure may transmit or receive high-frequency signals through a radiation area, and the radiation area may include a portion of a key case formed of a non-metallic material.

According to various embodiments, the key assembly may further include a first heat dissipation sheet disposed in contact between the antenna structure and the first bracket and a second heat dissipation sheet disposed in contact between the first bracket and the second bracket.

According to various embodiments, as viewed from above the key case, the wireless communication circuit of the antenna structure, the first heat dissipation sheet, the first bracket, the second heat dissipation sheet, and a portion of the second bracket may be disposed to overlap.

It is apparent to one of ordinary skill in the art that the key assembly and the electronic device including the same according to various embodiments of the present invention as described above are not limited to the above-described embodiments and those shown in the drawings, and various changes, modifications, or alterations may be made thereto without departing from the scope of the present invention.

## Claims

1. An electronic device (101) comprising:
a housing (200a, 320, 602) including a first opening (602a);
a key case (610) including an outer surface (611) formed to face in a first direction to cover the first opening and a recess formed to face in a second direction opposite to the first direction;
an antenna structure (620) seated in the recess of the key case and including an array of a plurality of conductive plates (621a) facing in the first direction;
a key circuit structure (640) for a key operation, disposed in the second direction of the antenna structure;
a first bracket (630) formed to surround at least a portion of the antenna structure and disposed between the antenna structure and the key circuit structure; and
a second bracket (650) supporting the key circuit structure and including a first portion (653a) formed to face the antenna structure and a second portion (653b) disposed in a direction different from the first portion and formed to face an inner area of the housing.

2. The electronic device of claim 1, wherein at least a portion of the key case facing in a direction in which the plurality of conductive plates face is formed of a non-metallic material.

3. The electronic device of claim 1, further comprising a first heat dissipation sheet (671) disposed between the antenna structure and the first bracket.

4. The electronic device of claim 3, further comprising:
a second heat dissipation sheet (672) disposed on the first portion of the second bracket to contact the first bracket; and
a third heat dissipation sheet (673) disposed on the second portion of the second bracket to contact the inner area of the housing.

5. The electronic device of claim 4, wherein heat generated from the antenna structure is diffused through the first heat dissipation sheet and the first bracket to the second heat dissipation sheet, the second bracket, and the third heat dissipation sheet to be transferred to the inner area of the housing.

6. The electronic device of claim 4, wherein at least one of the first heat dissipation sheet, the second heat dissipation sheet, or the third heat dissipation sheet includes at least one material among carbon nanotubes, a natural regenerated material, silicone, silicon, or graphite.

7. The electronic device of claim 1, wherein the key case includes:
a side surface (612) formed along an edge to form the recess; and
a first coupling portion (615) disposed adjacent to the side surface to couple with the first bracket.

8. The electronic device of claim 1, wherein the antenna structure includes:
an antenna circuit board (621);
the plurality of conductive plates disposed on one surface of the antenna circuit board facing in the first direction; and
a wireless communication circuit disposed on one surface of the antenna circuit board facing in the second direction, electrically connected with the plurality of conductive plates, and configured to transmit and/or receive a radio frequency (RF) signal.

9. The electronic device of claim 8, wherein the antenna structure transmits and/or receives a signal having a designated frequency band ranging from 6GHz to 300GHz through the plurality of conductive plates.

10. The electronic device of claim 1, wherein the first bracket includes:
a base portion (631) overall supporting the antenna structure;
a supporting portion (632) protruding toward the key case to be disposed in contact with an edge area of the key case; and
an actuator portion (634) formed on a surface of the base portion facing in the second direction.

11. The electronic device of claim 1, wherein the actuator portion includes:
a first area provided in a shape corresponding to a dome switch of the key circuit structure for the key operation; and
a second area disposed adjacent to the first area and formed to have a line shape to provide rigidity of the actuator portion.

12. The electronic device of claim 11, wherein the first bracket further includes:
an elastic portion (635) disposed adjacent to the actuator portion to prevent impact caused when the actuator portion contacts the dome switch of the key circuit structure; and
a second coupling portion (636) for coupling with the key case.

13. The electronic device of claim 1, wherein the key circuit structure includes:
a key circuit board (642);
a base member (641) supporting the key circuit board and having two opposite end portions formed to surround at least a portion of the key circuit board; and
a dome switch (643) disposed on the key circuit board.

14. The electronic device of claim 1, wherein the second bracket includes:
a first supporting area (651) overall supporting the key circuit structure; and
a second supporting area (652) connected with the first supporting area to provide a space for receiving the key circuit structure.

15. The electronic device of claim 14, wherein the second bracket is formed of a metallic material and further includes a protrusion (654) formed to protrude from an end portion of the first supporting area to couple with a portion of the housing near the first opening, and
wherein the second supporting area is disposed to face the first supporting area and includes the first portion forming one surface in a smaller area than the second supporting area and a third portion extending from an upper end portion of the first supporting area and formed in a third direction perpendicular to the first direction.

## Patentansprüche

1. Elektronische Vorrichtung (101), umfassend:
Eine Einhausung (200a, 320, 602) mit einer ersten Öffnung (602a);
ein Tastengehäuse (610) mit einer Außenfläche (611), die dazu gebildet ist, in eine erste Richtung zu weisen, um die erste Öffnung abzudecken, und einer Aussparung, die dazu gebildet ist, in eine zweite Richtung entgegengesetzt zu der ersten Richtung zu weisen;
eine Antennenstruktur (620), die in der Aussparung des Tastengehäuses sitzt und mit einem Array einer Vielzahl von leitfähigen Platten (621a), die in die erste Richtung weisen;
eine Tastenschaltungsstruktur (640) für einen Tastenbetrieb, die in der zweiten Richtung der Antennenstruktur angeordnet ist;
eine erste Halterung (630), die dazu gebildet ist, mindestens einen Abschnitt der Antennenstruktur zu umgeben, und zwischen der Antennenstruktur und der Tastenschaltungsstruktur angeordnet ist; und
eine zweite Halterung (650), die die Tastenschaltungsstruktur trägt und einen ersten Abschnitt (653a), der dazu gebildet ist, der Antennenstruktur zugewandt zu sein, und einen zweiten Abschnitt (653b) beinhaltet, der in einer Richtung angeordnet ist, die sich von dem ersten Abschnitt unterscheidet und dazu gebildet ist, einem Innenbereich der Einhausung zugewandt zu sein.

2. Elektronische Vorrichtung nach Anspruch 1, wobei mindestens ein Abschnitt des Tastengehäuses, der in eine Richtung weist, in die die Vielzahl von leitfähigen Platten weisen, aus einem nichtmetallischen Material gebildet ist.

3. Elektronische Vorrichtung nach Anspruch 1, ferner umfassend eine erste Wärmeableitungslage (671), die zwischen der Antennenstruktur und der ersten Halterung angeordnet ist.

4. Elektronische Vorrichtung nach Anspruch 3, ferner umfassend:
eine zweite Wärmeableitungslage (672), die auf dem ersten Abschnitt der zweiten Halterung angeordnet ist, um die erste Halterung zu kontaktieren; und
eine dritte Wärmeableitungslage (673), die auf dem zweiten Abschnitt der zweiten Halterung angeordnet ist, um den Innenbereich der Einhausung zu kontaktieren.

5. Elektronische Vorrichtung nach Anspruch 4, wobei von der Antennenstruktur erzeugte Wärme durch die erste Wärmeableitungslage und die erste Halterung zu der zweiten Wärmeableitungslage, der zweiten Halterung und der dritten Wärmeableitungslage diffundiert wird, um auf den Innenbereich der Einhausung übertragen zu werden.

6. Elektronische Vorrichtung nach Anspruch 4, wobei mindestens eine der ersten Wärmeableitungslage, der zweiten Wärmeableitungslage oder der dritten Wärmeableitungslage mindestens ein Material unter Kohlenstoffnanoröhren, einem natürlichen regenerierten Material, Silikon, Silizium oder Graphit beinhaltet.

7. Elektronische Vorrichtung nach Anspruch 1, wobei das Tastengehäuse beinhaltet:
eine Seitenfläche (612), die entlang einer Kante gebildet ist, um die Aussparung zu bilden; und
einen ersten Kopplungsabschnitt (615), der benachbart zu der Seitenfläche angeordnet ist, um mit der ersten Halterung zu koppeln.

8. Elektronische Vorrichtung nach Anspruch 1, wobei die Antennenstruktur beinhaltet:
eine Antennenleiterplatte (621);
die Vielzahl von leitfähigen Platten, die auf einer Oberfläche der Antennenleiterplatte angeordnet sind und in die erste Richtung weisen; und
eine drahtlose Kommunikationsschaltung, die auf einer Oberfläche der Antennenleiterplatte angeordnet ist, die in die zweite Richtung weist, elektrisch mit der Vielzahl von leitfähigen Platten verbunden ist und dazu konfiguriert ist, ein Hochfrequenz(HF)-Signal zu senden und/oder zu empfangen.

9. Elektronische Vorrichtung nach Anspruch 8, wobei die Antennenstruktur ein Signal mit einem designierten Frequenzband im Bereich von 6 GHz bis 300 GHz durch die Vielzahl von leitfähigen Platten überträgt und/oder empfängt.

10. Elektronische Vorrichtung nach Anspruch 1, wobei die erste Halterung beinhaltet:
einen Basisabschnitt (631), der die Antennenstruktur insgesamt trägt;
einen Tragabschnitt (632), der hin zu dem Tastengehäuses vorsteht, um in Kontakt mit einem Kantenbereich des Tastengehäuses angeordnet zu sein; und
einen Betätigungsabschnitt (634), der auf einer Oberfläche des Basisabschnitts gebildet ist, der in die zweite Richtung weist.

11. Elektronische Vorrichtung nach Anspruch 1, wobei der Betätigungsabschnitt beinhaltet:
einen ersten Bereich, der in einer Form bereitgestellt ist, die einem Kuppelschalter der Tastenschaltungsstruktur für den Tastenbetrieb entspricht; und
einen zweiten Bereich, der benachbart zu dem ersten Bereich angeordnet und so gebildet ist, dass er eine Linienform aufweist, um für Steifigkeit des Betätigungsabschnitts zu sorgen.

12. Elektronische Vorrichtung nach Anspruch 11, wobei die erste Halterung ferner beinhaltet:
einen elastischen Abschnitt (635), der benachbart zu dem Betätigungsabschnitt angeordnet ist, um einen Stoß zu verhindern, der verursacht wird, wenn der Betätigungsabschnitt den Kuppelschalter der Tastenschaltungsstruktur kontaktiert; und
einen zweiten Kopplungsabschnitt (636) zum Koppeln mit dem Tastengehäuse.

13. Elektronische Vorrichtung nach Anspruch 1, wobei die Tastenschaltungsstruktur beinhaltet:
eine Tastenleiterplatte (642);
ein Basiselement (641), das die Tastenleiterplatte trägt und zwei gegenüberliegende Endabschnitte aufweist, die gebildet sind, um mindestens einen Abschnitt der Tastenleiterplatte zu umgeben; und
einen Kuppelschalter (643), der auf der Tastenleiterplatte angeordnet ist.

14. Elektronische Vorrichtung nach Anspruch 1, wobei die zweite Halterung beinhaltet:
einen ersten Tragbereich (651), der die Tastenschaltungsstruktur insgesamt trägt; und
einen zweiten Tragbereich (652), der mit dem ersten Tragbereich verbunden ist, um einen Raum zum Aufnehmen der Tastenschaltungsstruktur vorzusehen.

15. Elektronische Vorrichtung nach Anspruch 14, wobei die zweite Halterung aus einem metallischen Material gebildet ist und ferner einen Vorsprung (654) beinhaltet, der dazu gebildet ist, aus einem Endabschnitt des ersten Tragbereichs vorzustehen, um mit einem Abschnitt der Einhausung nahe der ersten Öffnung zu koppeln, und
wobei der zweite Tragbereich so angeordnet ist, dass er dem ersten Tragbereich zugewandt ist und den ersten Abschnitt, der eine Oberfläche in einem kleineren Bereich als der zweite Tragbereich bildet, und einen dritten Abschnitt beinhaltet, der sich von einem oberen Endabschnitt des ersten Tragbereichs erstreckt und in einer dritten Richtung senkrecht zu der ersten Richtung gebildet ist.

## Revendications

1. Dispositif électronique (101) comprenant :
un boîtier (200a, 320, 602) comprenant une première ouverture (602a) ;
un carter de clé (610) comprenant une surface extérieure (611) formée pour être orientée dans une première direction afin de couvrir la première ouverture et un évidement formé pour être orienté dans une deuxième direction opposée à la première direction ;
une structure d'antenne (620) logée dans l'évidement du carter de clé et comprenant un réseau d'une pluralité de plaques conductrices (621a) orientées dans la première direction ;
une structure de circuit de clé (640) pour l'actionnement d'une clé, disposée dans la deuxième direction de la structure d'antenne ;
un premier support (630) formé pour entourer au moins une partie de la structure d'antenne et disposé entre la structure d'antenne et la structure de circuit de clé ; et
un second support (650) soutenant la structure de circuit de clé et comprenant une première partie (653a) formée pour faire face à la structure d'antenne et une deuxième partie (653b) disposée dans une direction différente de la première partie et formée pour faire face à une zone intérieure du boîtier.

2. Dispositif électronique de la revendication 1, dans lequel au moins une partie du carter de clé orientée dans une direction dans laquelle la pluralité de plaques conductrices sont orientées est formée d'un matériau non métallique.

3. Dispositif électronique de la revendication 1, comprenant en outre une première feuille de dissipation thermique (671) disposée entre la structure d'antenne et le premier support.

4. Dispositif électronique de la revendication 3, comprenant en outre :
une deuxième feuille de dissipation thermique (672) disposée sur la première partie du second support pour entrer en contact avec le premier support ; et
une troisième feuille de dissipation thermique (673) disposée sur la deuxième partie du second support pour entrer en contact avec la zone intérieure du boîtier.

5. Dispositif électronique de la revendication 4, dans lequel la chaleur générée par la structure d'antenne est diffusée à travers la première feuille de dissipation thermique et le premier support vers la deuxième feuille de dissipation thermique, le second support et la troisième feuille de dissipation thermique pour être transférée vers la zone intérieure du boîtier.

6. Dispositif électronique de la revendication 4, dans lequel au moins l'une de la première feuille de dissipation thermique, de la deuxième feuille de dissipation thermique ou de la troisième feuille de dissipation thermique comprend au moins un matériau parmi des nanotubes de carbone, un matériau régénéré naturel, le silicone, le silicium ou le graphite.

7. Dispositif électronique de la revendication 1, dans lequel le carter de clé comprend :
une surface latérale (612) formée le long d'un bord pour former l'évidement ; et
une première partie de couplage (615) disposée adjacente à la surface latérale pour s'accoupler au premier support.

8. Dispositif électronique de la revendication 1, dans lequel la structure d'antenne comprend :
une carte de circuit d'antenne (621) ;
la pluralité de plaques conductrices disposées sur une surface de la carte de circuit d'antenne orientée dans la première direction ; et
un circuit de communication sans fil disposé sur une surface de la carte de circuit d'antenne orientée dans la deuxième direction, connecté électriquement à la pluralité de plaques conductrices, et configuré pour transmettre et/ou recevoir un signal radiofréquence (RF).

9. Dispositif électronique de la revendication 8, dans lequel la structure d'antenne transmet et/ou reçoit un signal possédant une bande de fréquence désignée allant de 6 GHz à 300 GHz à travers la pluralité de plaques conductrices.

10. Dispositif électronique de la revendication 1, dans lequel le premier support comprend :
une partie de base (631) soutenant globalement la structure d'antenne ;
une partie de soutien (632) faisant saillie vers le carter de clé pour être disposée en contact avec une zone de bord du carter de clé ; et
une partie actionneur (634) formée sur une surface de la partie de base orientée dans la deuxième direction.

11. Dispositif électronique de la revendication 1, dans lequel la partie actionneur comprend :
une première zone prévue dans une forme correspondant à un commutateur en dôme de la structure de circuit de clé pour l'actionnement d'une clé ; et
une seconde zone disposée adjacente à la première zone et formée de manière à avoir une forme linéaire afin d'assurer la rigidité de la partie actionneur.

12. Dispositif électronique de la revendication 11, dans lequel le premier support comprend en outre :
une partie élastique (635) disposée adjacente à la partie actionneur pour empêcher un impact provoqué lorsque la partie actionneur entre en contact avec le commutateur en dôme de la structure de circuit de clé ; et
une seconde partie de couplage (636) pour s'accoupler avec le carter de clé.

13. Dispositif électronique de la revendication 1, dans lequel la structure de circuit de clé comprend :
une carte de circuit de clé (642) ;
un élément de base (641) soutenant la carte de circuit de clé et possédant deux parties d'extrémité opposées formées pour entourer au moins une partie de la carte de circuit de clé ; et
un commutateur en dôme (643) disposé sur la carte de circuit de clé.

14. Dispositif électronique de la revendication 1, dans lequel le second support comprend :
une première zone de soutien (651) soutenant globalement la structure de circuit de clé ; et
une seconde zone de soutien (652) reliée à la première zone de soutien pour fournir un espace pour recevoir la structure de circuit de clé.

15. Dispositif électronique de la revendication 14, dans lequel le second support est formé d'un matériau métallique et comprend en outre une saillie (654) formée pour faire saillie à partir d'une partie d'extrémité de la première zone de soutien afin de s'accoupler à une partie du boîtier près de la première ouverture, et
dans lequel la seconde zone de soutien est disposée pour faire face à la première zone de soutien et comprend la première partie formant une surface dans une zone plus petite que la seconde zone de soutien et une troisième partie s'étendant à partir d'une partie d'extrémité supérieure de la première zone de soutien et formée dans une troisième direction perpendiculaire à la première direction.
